# EUROPEAN PATENT SPECIFICATION

(11) **EP 4 110 969 B1**
(45) Date of publication and mention of the grant of the patent: **10.12.2025**
(21) Application number: 21781234.6
(22) Date of filing: 29.03.2021
(51) Int. Cl.: C23C 16/40, C23C 16/50, H01L 21/02, C07F 7/18

(54) **NEW PRECURSORS FOR DEPOSITING FILMS WITH HIGH ELASTIC MODULUS**
NEUE VORLÄUFER ZUR ABSCHEIDUNG VON FILMEN MIT HOHEM ELASTIZITÄTSMODUL
NOUVEAUX PRÉCURSEURS POUR LE DÉPÔT DE FILMS À MODULE D'ÉLASTICITÉ ÉLEVÉ

(30) Priority: 31.03.2020 US 202063003068 P; 22.10.2020 US 202063104440 P
(43) Date of publication of application: 04.01.2023
(73) Proprietor: Versum Materials US, LLC, Tempe, AZ 85284 (US)
(72) Inventor: XIAO, Manchao, Tempe, Arizona 85284 (US); ENTLEY, William Robert, Tempe, Arizona 85284 (US); SPENCE, Daniel P., Tempe, Arizona 85284 (US); NICHOLAS, Raymond, Tempe, Arizona 85284 (US); ACHTYL, Jennifer Lynn Anne, Tempe, Arizona 85284 (US); RIDGEWAY, Robert Gordon, Tempe, Arizona 85284 (US); LEI, Xinjian, Tempe, Arizona 85284 (US)
(74) Representative: Sommer, Andrea
(86) International application number: PCT/US2021/024581
(87) International publication number: WO 2021/202335

(56) References cited:
- WO-A1-00/02241
- KR-A- 20180 069 769
- US-A- 3 478 078
- US-A1- 2005 147 833
- US-A1- 2007 098 890
- US-A1- 2016 336 190
- US-A1- 2017 117 134
- US-A1- 2017 207 083
- US-A1- 2019 139 757
- STEELE KENT P. ET AL: "Solvent Modified Reactivity of Dimethylsilylene", J. AM. CHEM. SOC., vol. 102, no. 19, 31 December 1980 (1980-12-31), pages 6095 - 6097, XP093078837, DOI: doi.org/10.1021/ja00539a020
- LEIGH WILLIAM J. ET AL: "Fast Kinetics Study of the Reactions of Transient Silylenes with Alcohols. Direct Detection of Silylene-Alcohol Complexes in Solution", ORGANOMETALLICS, vol. 29, no. 3, 8 January 2010 (2010-01-08), pages 662 - 670, XP093078859, ISSN: 0276-7333, DOI: 10.1021/om9009747
- LEIGH WILLIAM J. ET AL: "Fast Kinetics Study of the Reactions of Transient Silylenes with Alcohols. Direct Detection of Silylene-Alcohol Complexes in Solution", ORGANOMETALLICS, vol. 29, no. 3, 8 January 2010 (2010-01-08), pages 662 - 670, XP93078859, ISSN: 0276-7333, DOI: 10.1021/om9009747
- DATABASE PUBCHEM COMPOUND ANONYMOUS: "Cyclopentyloxy(Dimethyl)Silicon", XP055855604, retrieved from COMPOUND Database accession no. AC1O3ID8

## Description

### CROSS-REFERENCE TO RELATED APPLICATIONS

This application for a patent claims priority to U.S. Provisional Patent Application No. 63/003,068, filed March 31, 2020, and U.S. Provisional Patent Application No. 63/104,440, filed October 22, 2020.

### BACKGROUND OF THE INVENTION

Described herein is a composition and method for formation of a dense organosilica dielectric film as described in the appended claims. More specifically, described herein is a composition and chemical vapor deposition (CVD) method for forming a dense film having a dielectric constant, k ≥ 2.7, wherein the as deposited film has a high electric field at breakdown, a low leakage current, strong resistance to plasma induced damage (PID), and a high mechanical properties as compared to films made from prior art precursors for the same value of the dielectric constant.

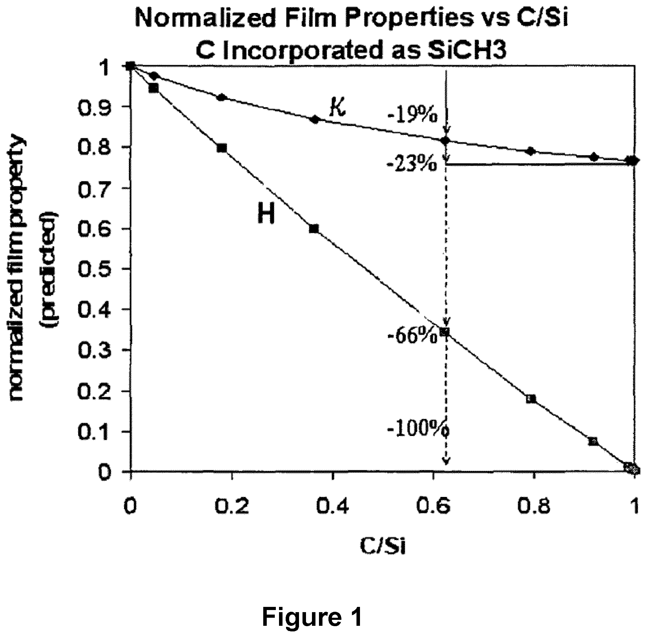

The electronics industry utilizes dielectric materials as insulating layers between circuits and components of integrated circuits (IC) and associated electronic devices. Line dimensions are being reduced in order to increase the speed and memory storage capability of microelectronic devices (e.g., computer chips). As the line dimensions decrease, the insulating requirements for the interlayer dielectric (ILD) become much more rigorous. Shrinking the spacing requires a lower dielectric constant to minimize the RC time constant, where R is the resistance of the conductive line and C is the capacitance of the insulating dielectric interlayer. Capacitance (C) is inversely proportional to spacing and proportional to the dielectric constant (k) of the interlayer dielectric (ILD). Conventional silica (SiO₂) CVD dielectric films produced from SiH₄ or TEOS (Si(OCH₂CH₃)₄, tetraethylorthosilicate) and O₂ have a dielectric constant k greater than 4.0. There are several ways in which industry has attempted to produce silica-based CVD films with lower dielectric constants, the most successful being the doping of the insulating silicon oxide film with organic groups providing dielectric constants ranging from about 2.7 to about 3.5. This organosilica glass (or low k film) is typically deposited as a dense film (density ~ 1.5 g/cm³) from an organosilicon precursor, such as a methylsilane or siloxane, and an oxidant, such as O₂ or N₂O. Organosilica glass will herein be referred to as OSG. As dielectric constant or "k" values drop below 2.7 with higher device densities and smaller dimensions, the industry has exhausted most of the suitable low k compositions for dense films and has turned to various porous materials for improved insulating properties. Unfortunately, while integrating organic groups and/or introducing porosity into the silicon oxide network reduces the dielectric constant, it also significantly decreases the mechanical properties of the film. Indeed, as taught in U.S. Pat. No. 8,137,764 and U.S. Pat. No. 9,922,818 the mechanical properties of a dense low k film decrease much faster than the dielectric constant as the percentage of organic groups in the low k silicon oxide-based network is increased (Figure 1). Similarly, the mechanical properties of a porous low k film decrease much faster than the dielectric constant as the percentage of porosity in the low k silicon oxide based network is increased. However, for the most advanced technology nodes in the lowest levels of the back end of line dense low k materials with the highest possible mechanical properties are needed. In addition to benefiting chip packaging and CMP, increased mechanical properties in low k films reduce line edge roughness in patterned features, reduce pattern collapse, and provide greater internal mechanical stress within an interconnect, reducing failures due to electromigration. The need for increased mechanical properties becomes more important as the pitch decreases in advanced technology nodes, particularly for the lowest layers in the back end of the line. This need has driven the search for new dense low k films with relatively high dielectric constants (k < 3.5) and the highest possible mechanical properties.

Multiple methods have been reported to increase the mechanical properties of low k films. These include, but are not limited to, thermal treatment (U.S. Pat. No. 6,846,515), broadband ultraviolet (UV) curing (U.S. Pat. No. 8,951,342), and the use of hardening additives (U.S. Pat. No. 8,137,764). However, the simplest method to improve the mechanical properties is to use a low k precursor that inherently results in the deposition of low k films with superior mechanical properties. For example, in U.S. Pat. No. 6,846,515 the diethoxymethylsilane (DEMS^{®}) precursor was shown to deposit low k films, with a k of 3.5 or less, that have unexpectedly superior mechanical properties as indicated by Young's modulus and nanoindentation hardness, compared to the alterative precursors trimethylsilane (TMS) and dimethyldimethoxysilane (DMDMOS). This was attributed to the DEMS^{®} based films having a higher oxygen content and a lower carbon content relative to the other films at the same value of the dielectric constant. The increased oxygen content likely results in better three-dimensional network connectivity, and thus the improved mechanical properties. The use of a single low k precursor that inherently results in the deposition of low k films with superior mechanical properties without additional post deposition steps (i.e., as deposited films) also results in a simplified process scheme with the lowest cost of ownership as the throughput is maximized (post deposition steps are not required) and additional hardware (i.e., a UV anneal chamber) is not required.

For dense low k films it is also recognized that as the number of silicon-alkoxy groups (e.g., Si-OCH₃, Si-OCH₂CH₃, etc.) in the low k precursor increases and the number of silicon-carbon bonds (e.g., Si-CH₃, Si-CH₂CH₃, etc.) in the precursor decreases, the dielectric constant and mechanical properties of an as deposited film increase and the carbon content of the film decreases. Thus, films deposited using precursors containing four silicon-alkoxy groups and containing no silicon-carbon bonds per silicon atom in the precursor (e.g., TEOS) have a higher dielectric constant, greater mechanical properties, and less carbon than films deposited using precursors containing three silicon-alkoxy groups per silicon and up to one silicon-carbon bond per silicon (e.g., triethoxysilane or TES and methyltriethoxysilane or MTES), which in turn have a higher dielectric constant, higher mechanical properties, and less carbon than films deposited using precursors containing two silicon-alkoxy groups and one or two silicon-carbon bonds per silicon (e.g., DEMS^{®} and DMDMOS), which in turn have a higher elastic modulus than films deposited using precursors containing only a single silicon-alkoxy group and up to three silicon-carbon bonds per silicon (e.g., diethyl-isopropoxy-methylsilane and trimethylsilane). Indeed, in U.S. Pat. No. 8,137,764 this concept was utilized to enhance the mechanical properties of dense low k films by depositing films using a controlled mixture of two different precursors during the deposition process. One precursor (the hardening additive), selected to increase the mechanical properties of the film, contained 3 to 4 silicon oxygen bonder per silicon atom and no silicon-carbon bonds, such as TEOS and triethoxysilane (TES). The second precursor, the low k precursor, contained one or more silicon-carbon bonds, such as DEMS^{®} or DMDMOS. A representative example would be the deposition of a low k film using a blend of TES (50%) and DEMS^{®} (50%). The resulting k = 3.17 film deposited using the blend of TES and DEMS^{®} had a higher hardness (1.76 GPa) than a film at a similar value of the dielectric constant deposited only using DEMS^{®} (1.58 GPa). The higher hardness of the low k film deposited from the blend TES and DEMS^{®} was attributed to the higher oxygen content, and presumably lower carbon content, of this film relative to the film deposited only from DEMS^{®}. The increased oxygen content, and decreased carbon content, likely results in better three-dimensional network connectivity, and thus improved mechanical properties.

While low k films deposited using a combination of a low k precursor containing a silicon carbon bond and a hardening additive do have improved mechanical properties, this strategy decreases the carbon content of the film and results in greater plasma or process induced damage (PID). Plasma or process induced damage in low k films is caused by the removal of carbon during plasma exposure, particularly during etch and photoresist strip processes (e.g., NH₃ based strip processes). Carbon depletion causes the plasma damaged region to change from hydrophobic to hydrophilic. Exposure of the hydrophilic plasma damaged region to dilute HF-based wet chemical post plasma treatments results in rapid dissolution of this damaged region and an increase in the k of the film (the hydrophobic damaged layer increases moisture update). In patterned low k films (created using etch and photoresist strip processes) exposure to a dilute HF-based post plasma treatment results in profile erosion. Profile erosion can result in the formation of re-entrant features (resulting in metallization defects) and reduced spacing between metal lines (resulting in increased capacitance). This is particularly problematic in advanced logic devices, where the depth of profile erosion can be a significant fraction of the logic ½ pitch. In general, the greater the carbon content of the low k film the lower the depth of PID. Process induced damage and the resulting profile erosion in low k films is a significant problem that device manufacturers must overcome when integrating low k materials in a ULSI interconnect, particularly for the lowest levels in the back end of the line. Thus, it is desirable to deposit low k films with the both the highest possible mechanical strength and the greatest resistance to PID. Unfortunately, these two factors often work in opposition to one another; while films with a higher carbon content exhibit a greater resistance to PID, the higher carbon content generally results in the incorporation of more terminal silicon methyl groups (Si-Me or Si(CH₃)ₓ) within the oxide network lowering the films mechanical strength (FIG. 1).

Molecular dynamics (MD) simulations show that the type of carbon incorporated into a low k film (i.e., a SiOCH matrix) can significantly impact its mechanical properties. Specifically, the MD simulations show that a low k film where the carbon is incorporated as bridging methylene groups (-SiCH₂Si-) will have a higher elastic modulus than low k films where carbon is incorporated as terminal methyl groups (-SiCH₃). Bridging carbon atoms maintain three-dimensional network connectivity, whereas the terminal carbon atoms disrupt the three-dimension network connectivity. Disrupting three-dimensional network connectivity results in decreased mechanical properties of the low k film. U.S. Pat. No. 7,892,648 teaches that one way to incorporate bridging carbon groups such as -SiCH₂Si- or - SiCH₂CH₂Si- into a low k film is to deposit the low k films using carbosilane precursors that contain the -SiCH₂Si- or SiCH₂CH₂Si- functional groups via a plasma enhanced chemical vapor deposition (PECVD) process. Alternatively, the bridging carbosilane precursors can be added to an existing low k PECVD process. However, there are three significant limitations associated with this approach. The first limitation is that carbosilane precursors are expensive. The second limitation is that bridged carbosilane precursors generally have a very high boiling point due to the increased molecular weight from having two silicon groups. The increased boiling point may negatively impact the manufacturing process by making it difficult to deliver the chemical precursor into the reaction chamber as a gas phase reagent without condensing it in the vapor delivery line or the process pump exhaust. The third limitation is that adding an expensive bridged carbosilane precursor to an existing deposition process increases the complexity of the deposition process. For example, three liquid delivery lines would be required on a PECVD tool to increase the density of -SiCH₂Si- or - SiCH₂CH₂Si- groups in a porous low k film using this approach: one liquid delivery line would be required for the structure former, one liquid delivery line would be required for the porogen, and one liquid delivery line would be required for the added carbosilane. As described above, many of the carbosilanes are also high molecular weight compounds with low vapor pressures, and depending upon the terminal groups, may be extremely flammable.

U.S. Pat. Appl. No. 2011/10113184 discloses a class of low k precursors that can be used to deposit insulating films with increased densities of -SiCH₂Si- groups and dielectric constants ranging from ~ k = 2.4 to k = 2.8 via a PECVD process. In U.S. Pat. Appl. No. 2011/10113184 low k films are deposited using Si based precursors where at least one branched hydrocarbon group R (e.g., an isobutyl, isopentyl, neopentyl, or neohexyl group) is attached to the silicon atom of the low k precursor via a methylene group (SiCH₂R). The inventors claim that during the deposition process a high density of SiCH₂Si groups forms within the film via plasma dissociation of the bond connecting the branched hydrocarbon group R to the methylene group in SiCH₂R. There are three significant limitations of this approach. The first limitation is that the incorporation of large branching alkyl groups in the precursor is expensive. The second limitation is that the incorporation of one or more large branching alkyl groups into the precursor generally results in precursors that have a very high boiling point due to the increased molecular weight from the large branching alkyl groups. The increased boiling point may negatively impact the manufacturing process by making it difficult to deliver the chemical precursor into the reaction chamber as a gas phase reagent without condensing it in the vapor delivery line or the process pump exhaust. The third limitation is that the high density of SiCH₂Si groups in low k films reported in U.S. Pat. Appl. No. 2011/10113184 appear to form after the as deposited films are UV annealed. Thus, the formation of SiCH₂Si groups in the low k films described in this patent application is likely due to UV curing (i.e., post treatment after the deposition process) rather than precursor selection. It is recognized that the increase in the density of SiCH₂Si groups upon exposure of a low k film to ultraviolet irradiation is well documented. The fourth limitation is that most of the values of the dielectric constant reported in this approach are low, less than or equal to 2.8. It is well established that the lowest dielectric constant achievable for dense low k films with reasonable mechanical properties is approximately 2.7 to 2.8. Thus, the approach disclosed US Publication US201110113184A is not related to the deposition of dense low k films in the absence of post deposition processing (i.e., UV annealing), but is more akin to a tethered porogen approach for generating porous low k films. US Publication US 2011/10113184 A discloses a method of lowering dielectric constant of an insulating film including Si, 0 and CH formed by a chemical vapor deposition process. The structure of the insulation film is modified by hydrogen radicals lowering the dielectric constant of the film. As precursors trimethylsilane, dimethylethoxysilane, tetramethylsilane or organic silicon alcoxide are disclosed. US Publication US 2011/10113184 A discloses a method for forming a low dielectric constant film on a substrate placed in a processing chamber inside a processing container. The method includes: generating plasma using microwaves by supplying at least a noble gas to a plasma generation chamber, which is formed above the processing chamber inside the processing container; forming a low dielectric constant film on the substrate by supplying particles from the plasma generation chamber to the processing chamber and supplying a precursor gas to the processing chamber through a shield unit provided between the plasma generation chamber and the processing chamber, the shield unit having a plurality of openings configured to communicate the plasma generation chamber with the processing chamber, and having a shielding property against ultraviolet light; and then, performing a heat treatment on the substrate. As precursors for example 1,3-dimethoxytetramethyldisiloxane is used.

Low k films with better intrinsic electrical properties, such as a lower leakage current density and a higher electric field at breakdown, are preferred for manufacturing advanced integrated circuits; minimum intrinsic electrical requirements typically include a leakage current density of less than 1x10⁻⁹ A/cm² at a field strength of 1 MV/cm and an electric breakdown field of 4 MV/cm or greater. Since the breakdown field in device structures decreases as dimensions are decreased (i.e., as devices scale in accordance with Moore's law), a low k material with the highest possible electric field at breakdown is preferred (> 4 MV/cm). This is particularly important in the lowest levels of the BEOL where the small dimensions can result in high electrical field strengths. It has also been reported that low leakage current levels ensure good reliability in integrated circuits. Since the small dimensions in the lowest levels of the BEOL can result in high electric field strengths, it is particularly important that the low k film exhibit the lowest possible leakage current at higher electric field strengths (≥ 4 MV/cm). Unfortunately, there are multiple challenges associated with depositing a low k film with an intrinsically low leakage current density. For example, the use of a single structure former precursor has been reported to result in high leakage current densities, presumably due to the formation of oxygen deficiency related defects. Further, low leakage current density also depends on post deposition treatments, such as UV annealing. To illustrate, it has been reported that as deposited low k films always have a higher leakage current density than the same film following UV annealing. This is a significant limitation as UV annealing increases equipment cost, process complexity, and reduces throughput. Thus, there is a need for as deposited low k films, deposited from a single structure former precursor, with better intrinsic electrical properties, specifically the lowest possible leakage current density, particularly at high field strengths (> 2 MV/cm), and the highest possible breakdown field (≥ 4 MV/cm).

Thus, particularly for lowest levels in the back end of the line, there is a need for volatile structure former low k precursors that can be used to deposit dense low k films that have high mechanical strength, a strong resistance to plasma induced damage, a leakage current density of less than 1x10⁻⁹ A/cm² at high field strengths (≥ 4 MV/cm), and a high breakdown voltage (> 5 MV/cm) at a given value of the dielectric constant (k ≤ 3.5). The precursors need to have a high vapor pressure (low molecular weight), facilitating delivery into the reaction chamber as a gas phase reagent without condensing in the vapor delivery line or the process pump exhaust. Further, the films deposited from such precursors should not require post deposition treatment, such as UV curing, to improve the films mechanical properties or the films electrical properties. That is, the intrinsic properties of the as deposited film should meet the requirements for integrated circuit manufacturing such that post deposition steps (i.e., UV curing) are not needed.

### BRIEF SUMMARY OF THE INVENTION

The method and composition described herein fulfill one or more needs described above. The method and composition described herein use a hydrido-dimethyl-alkoxysilane compound(s), for example, such as dimethyl-sec-butoxysilane (DMSBOS), as a structure former to deposit dense low dielectric films that, after removal from the deposition chamber, have mechanical properties equivalent to or greater than films deposited from high mechanical strength prior art structure formers such as DEMS^{®} at the same value of the dielectric constant. Further, the films deposited using the hydrido-dimethyl-alkoxysilane precursors described herein as the structure former precursor(s) contain a relatively high amount of carbon incorporated as disilylmethylene groups as measured by infrared spectroscopy (the relative SiCH₂Si density > 10 as measured by infrared spectroscopy). Further, the total carbon content of films deposited using the hydrido-dimethyl-alkoxysilane precursors as measured by XPS is relatively low (< ~ 25 atomic %). Thus, the percentage of total carbon comprised of disilylmethylene groups in films deposited using hydrido-dimethyl-alkoxysilane precursors is high (> 0.65, calculated as the ratio of the relative SiCH₂Si density measured by infrared spectroscopy to the XPS carbon content of the film) compared to other prior art structure former precursors, for example, such as DEMS^{®} and 1-methyl-1-isopropoxy-1-silacyclopentane (MIPSCP). In addition, the hydrido-dimethyl-alkoxysilane precursors described herein have a lower molecular weight relative to other prior art structure former precursors such as bridged precursors (e.g., carbosilane such as 1,1,4,4-tetraethoxy-1,4-disilabutane or disiloxane such as hexaethoxy-disiloxane) which by nature of having 2 silicon groups have a higher molecular weight (MW) and higher boiling points, thereby making the hydrido-dimethyl-alkoxysilane precursors described herein more convenient to process, for example, in a high-volume manufacturing process.

Described herein is a low dielectric constant film comprising: a material represented by the formula SiᵥO_{w}CₓH_{y}, where v+w+x+y=100%, v is from 10 to 35 atomic %, w is from 10 to 65 atomic %, x is from 5 to 45 atomic %, and y is from 10 to 50 atomic %, wherein the film has a dielectric constant from ~ 2.70 to ~ 3.5. In certain embodiments the film exhibits a decreased depth of carbon removal when exposed to, for example an O₂ or NH₃ plasma as measured by examining the carbon content determined by dynamic SIMS depth profiling. Further, in certain embodiments, as measured by a Hg probe, the film has a leakage current density of less than 1x10⁻⁹ A/cm² at an electric field strength of ≥ 4 MV/cm and an electric field at breakdown of ≥ 5 MV/cm. The desired film properties are observed in as deposited films from hydrido-dimethyl-alkoxysilane precursors without the need for post deposition treatment steps, such as UV curing.

In one aspect, there is provided a composition as described in the appended claims.

In a further aspect, there is provided a chemical vapor deposition method as described in the appended claims
Preferably where the alkyl group is selected such that the molecules boiling point is less than 200 °C, preferably less than 150 °C, and R may also be selected such that the R group forms secondary or tertiary radicals upon homolytic bond dissociation of the SiO-R bond (e.g., SiO-R → SiO· + R·, where R· is a secondary or tertiary radical such as an isopropyl radical, a sec-butyl radical, a tert-butyl radical, a sec-pentyl radical, a tert-pentyl radical, a cyclopentyl radical, or a cyclohexyl radical); and applying energy to the gaseous composition comprising a hydrido-dimethyl-alkoxysilane in the reaction chamber to induce reaction of the gaseous composition comprising the hydrido-dimethyl-alkoxysilane to deposit an organosilicon film on the substrate, wherein the deposited dense organosilica film has a dielectric constant from ~ 2.70 to ~ 3.50.

### BRIEF DESCRIPTION OF THE DRAWINGS

Fig. **1** illustrates the predicted relationship between dielectric constant and hardness as the C/Si ratio of a material in increased, with all of the parameters of the material normalized to those of SiO₂, and assuming that all of the C is incorporated into material as methyl groups attached to the silicon.
Fig. **2** shows the IR spectra between 3500 cm⁻¹ and 500 cm⁻¹ for comparative example 1 and inventive example 2, inventive example 4, and inventive example 5. Absorbancies were normalized to film thickness, background corrected for the bare Si wafer, and baseline offset for clarity.
Fig. **3** shows the IR spectra between 1390 cm⁻¹ and 1330 cm⁻¹ for comparative example 1 and inventive example 2, inventive example 4, and inventive example 5. Absorbancies were normalized to film thickness, background corrected for the bare Si wafer, and baseline offset for clarity.
Fig. **4** shows the IR spectra between 1300 cm⁻¹ and 1240 cm⁻¹ for comparative example 1 and inventive example 2, inventive example 4, and inventive example 5. Absorbancies were normalized to film thickness, background corrected for the bare Si wafer, and baseline offset for clarity.
Fig. **5** shows the relationship between dielectric constant and XPS carbon content for a series of low dielectric films deposited using the inventive compound DMTBOS relative to a series of low dielectric films deposited using the comparative compound DEMS^{®}.
Fig. **6** shows the relationship between dielectric constant and the relative SiCH₂Si density determined by infrared spectroscopy for a series of low dielectric films deposited using the inventive compound DMTBOS relative to a series of low dielectric films deposited using the comparative compound DEMS^{®}.
Fig. **7** shows the relationship between dielectric constant and the hardness for a series of low dielectric films deposited using the inventive compound DMTBOS relative to a series of low dielectric films deposited using the comparative compound DEMS^{®}.
Fig. **8** shows the measured current density as a function of applied electric field strength for comparative example 3 and inventive example 6.
Fig. **9** shows the measured current density as a function of applied electric field strength for inventive example 1, inventive example 7, and inventive example 8.
Fig. **10** demonstrates the resistance to carbon removal of comparative film 1, comparative film 2, inventive film 1, and inventive film 5 after the films were damaged using an NH₃ plasma.
Fig. **11** shows the measured current density as a function of applied electric field strength for comparative example 4 for both the as deposited and UV annealed films.
Fig. **12** shows the measured current density as a function of applied electric field strength for inventive example 4 for both the as deposited and UV annealed films.

### DETAILED DESCRIPTION OF THE INVENTION

Described herein is a chemical vapor deposition method as described in the appended claims. It is recognized that organosilica films with the desired film properties can also be deposited using a gaseous composition that does not include an oxidant.

The hydrido-dimethyl-alkoxysilane compounds described herein provide unique attributes that make it possible to deposit a dense as deposited OSG film with a relatively low dielectric constant and with a surprisingly low leakage current density at high field strength (4 MV/cm) compared to as films made using other prior art structure former precursors such as diethoxymethylsilane (DEMS^{®}). Surprisingly, the electric field at breakdown (E_{BD}) of as deposited films made using the hydrido-dimethyl-alkoxysilane precursors described herein is also significantly higher than as deposited films made using other prior art structure former precursors such as DEMS^{®}.

A further unique attribute of as deposited films from hydrido-dimethyl-alkoxysilane structure former precursors is that they have a relatively low total carbon content (typically less than 25 atomic percent by XPS) yet exhibit an exceptionally high resistance to carbon removal when exposed to an NH₃ or O₂ plasma. It is well established that the resistance to carbon removal from a dielectric film increases as the total carbon content of the film increases. That is, a film with a high total carbon content will exhibit a smaller depth of carbon removal when exposed to an NH₃ or O₂ plasma than a film with a lower total carbon content. This is illustrated in U.S. patent 9,922,818 where the depth of carbon removal for a low k film containing 36% carbon (XPS, atomic %) is 20% less (35 nm compared to 44 nm) than a low k film containing 23% carbon (XPS, atomic %). Thus, it is unexpected that a dielectric film made using a hydrido-dimethyl-alkoxysilane structure former precursor containing a relatively low total carbon content (< ~ 25%, as measured by XPS) can exhibit the same depth of carbon removal when exposed to an NH₃ or O₂ plasma as a dielectric film made using a precursor designed to deposit films with a high total carbon content (> ~ 25%, as measured by XPS). As disclosed in U.S. patent 9,922,818 precursors such as 1-methyl-1-isopropoxy-1-silacyclopentane (MIPSCP) can be used to make films with a high total carbon content (> ~ 25%) and an exceptional resistance to carbon removal when exposed to an NH₃ or O₂ plasma.

The unique attributes of hydrido-dimethyl-alkoxysilane compounds in Formula (1) also make it possible to achieve a relatively low dielectric constant for a dense OSG film and for such films to surprisingly exhibit mechanical properties equivalent to or greater than films deposited from prior art structure former precursors designed for high mechanical strength such as DEMS^{®}. For example, DEMS^{®} provides a mixed ligand system with two alkoxy groups, one methyl, and one hydride which offers a balance of reactive sites and allows for the formation of more mechanically robust films while retaining the desired dielectric constant. For dense low dielectric films, it is also recognized that as the number of silicon-alkoxy groups (e.g., Si-OCH₃, Si-OCH₂CH₃, etc.) in the low k precursor increases and the number of silicon-carbon bonds (e.g., Si-CH₃, Si-CH₂CH₃, etc.) in the precursor decreases, the dielectric constant and mechanical properties of an as deposited film will increase, and the carbon content of the film will decrease. Thus, films made using precursors containing two silicon-alkoxy groups and one silicon-carbon bond per silicon atom in the precursor, such as, for example the DEMS^{®} prior art structure former designed for high mechanical strength, would be expected to have higher mechanical properties and a lower carbon content than films made using precursors containing only one silicon-alkoxy group and two silicon-carbon bonds per silicon, such as, for example, the hydrido-dimethyl-alkoxysilane compounds in Formula (1). Unexpectedly, films made using the hydrido-dimethyl-alkoxysilane compounds in Formula (1) have mechanical properties equivalent to or greater than films made using the DEMS^{®} structure former at the same value of the dielectric constant. Also, unexpectedly, the films made using the hydrido-dimethyl-alkoxysilane compounds in Formula (1) have a similar total carbon content, as measured by XPS, relative to that of films made using the DEMS^{®} structure former at the same value of the dielectric constant. Preferable examples of the hydrido-dimethyl-alkoxysilane compound represented by general Formula (1) include, but not limited to, the following hydrido-dimethyl-alkoxysilane compounds with their corresponding structures.

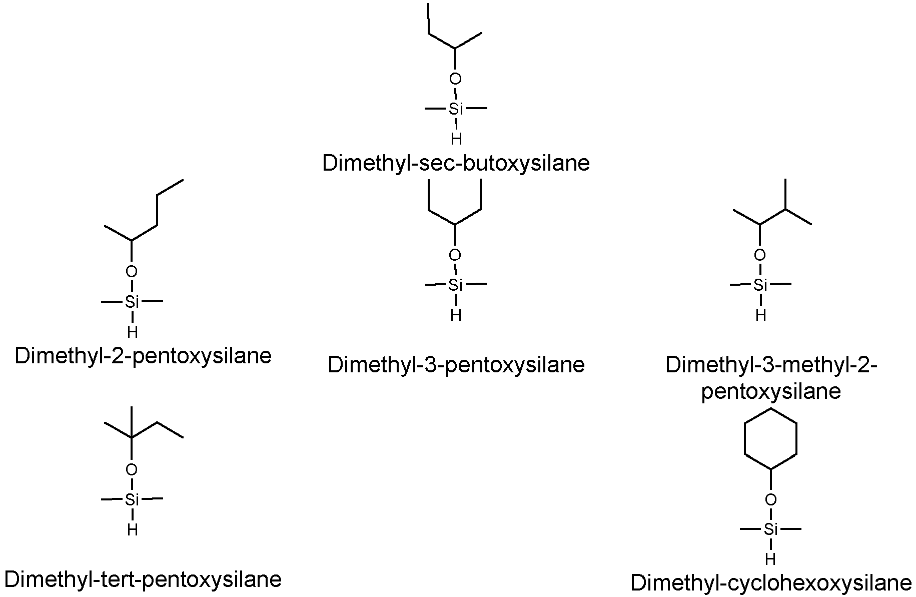

The hydrido-dimethyl-alkoxysilane compounds described herein provide unique attributes that make it possible for one to incorporate a different distribution of the type of carbon in the dielectric film compared to prior art structure former precursors such as diethoxymethylsilane (DEMS^{®}) and MIPSCP. For example, in dense OSG films deposited using DEMS^{®} as the structure former the carbon in the film exists mainly in the form of terminal Si-Me groups (Si(CH₃)); a small density of disilylmethene groups (SiCH₂Si) may also be present in the film. While the hydrido-dimethyl-alkoxysilane precursors described herein, such as dimethyl-sec-butoxysilane (DMSBOS), can be used to deposit dense OSG films with approximately the same total carbon content of DEMS^{®} based films at a given value of the dielectric constant, the distribution of carbon in films made using hydrido-dimethyl-alkoxysilane precursors is different. Films made using hydrido-dimethyl-alkoxysilane precursors have a lower concentration of terminal Si-Me groups (Si(CH₃)) and a much higher concentration of bridging SiCH₂Si groups. That is, since the total carbon content of films made using the prior art structure former DEMS^{®} is approximately the same films made using the inventive hydrido-dimethyl-alkoxysilane precursors, a much greater percentage of the total carbon in films deposited from the inventive hydrido-dimethyl-alkoxysilane precursors is incorporated as bridging SiCH₂Si groups compared to prior art structure former precursors such as DEMS^{®}.

Whereas prior art silicon-containing structure-forming precursors, for example DEMS^{®}, polymerize, once energized in the reaction chamber to form a structure having an - O- linkage (e.g., -Si-O-Si or -Si-O-C-) in the polymer backbone, hydrido-dimethyl-alkoxysilane compounds, such as, for example, the DMTBOS molecule polymerizes in such a way to form a structure where, some of the -O- bridge in the backbone is replace with a - CH₂- methylene bridge. In films deposited using DEMS^{®} as the structure forming precursor where the carbon exists mainly in the form of terminal Si-Me groups there is a relationship between the % Si-Me versus mechanical strength, see for example the predicted relationship between hardness as the C/Si ratio of a material in increased, assuming that all of the C is incorporated into the material as methyl groups attached to the silicon, where the replacement of a bridging Si-O-Si group with two terminal Si-Me groups decreases the mechanical properties because the network structure is disrupted. Not to be bound by theory, in the case of hydrido-dimethyl-alkoxysilane compounds it is believed that the precursor structure facilitates reactions in the plasma that convert a high percentage of the two terminal Si-Me groups (Si(CH₃)) in the structure former into bridging methylene groups in the structure (disilylmethylene, SiCH₂Si). In this manner, one can incorporate carbon in the form of a bridging group so that, from a mechanical strength view, the network structure is not disrupted by increasing the carbon content in the film. This also adds carbon to the film, allowing the film to be more resilient to carbon depletion from processes such as etching of the film, plasma ashing of photoresist, and NH₃ plasma treatment of copper surfaces. Another unique attribute of films made using hydrido-dimethyl-alkoxysilane compounds of Formula (1), for example, such as DMSBOS, is that the total carbon content is rather low (< 25%) and the percentage of the total carbon content comprised of SiCH₂Si groups is high compared to prior art structure formers such as DEMS^{®} and MIPSCP.

Other prior art structure former precursors, such as 1-methyl-1-isopropoxy-1-silacylcopentane (MIPSCP) can deposit dense OSG films with a high concentration of disilylmethylene groups (SiCH₂Si). However, dense OSG films deposited from MIPSCP that contain a high concentration of disilylmethylene groups (SiCH₂Si) also have a high total carbon content, resulting in a smaller percentage of the total carbon being incorporated as disilylmethylene groups compared to dense OSG films deposited from hydrido-dimethyl-alkoxysilane precursors described herein, such as dimethyl-sec-butoxysilane (DMSBOS). Further, dense OSG films deposited from MIPSCP also contain a high concentration of terminal Si-Me groups (Si(CH₃)ₓ). As shown in Figure 1, the high concentration of terminal Si-Me groups negatively impacts the films mechanical strength, ultimately limiting the highest mechanical strength achievable using MIPSCP as the structure former.

The hydrido-dimethyl-alkoxysilane provides unique attributes that make it possible to achieve a relatively low dielectric constant for a dense organosilica film and to surprisingly exhibit excellent mechanical properties compared to prior art structure former precursors such as diethoxymethylsilane (DEMS) and 1-ethoxy-1-methylsilacyclopentane (MESCP). Not bound by theory, it is believed hydrido-dimethyl-alkoxysilanes in this invention can provide stable radicals such as (CH₃)₂CH·, (CH₃)(CH₃CH₂)HC·, (CH₃)₃C·, sec-pentyl, tert-pentyl, cyclopentyl, and cyclohexyl (depending upon the alkoxy group in the hydrido-dimethyl-alkoxysilane), during plasma enhanced chemical vapor deposition when R is selected from the group consisting of a branched or cyclic C₃ to C₁₀ alkyl, such as iso-propyl, sec-butyl, iso-butyl, tert-butyl, sec-pentyl, tert-pentyl, cyclopentyl, or cyclohexyl. The higher density of stable radicals such as (CH₃)₂CH·, (CH₃)(CH₃CH₂)HC·, (CH₃)₃C·, sec-pentyl, tert-pentyl, cyclopentyl, and cyclohexyl in the plasma increase the probability of abstraction of a hydrogen atom from one of the terminal silicon methyl groups (Si-(CH₃)₂) in the precursor (forming SiCH₂·) and facilitate the formation of bridging Si-CH₂-Si groups in the as deposited film. Presumably in the case of HMe₂SiOR the presence of two terminal silicon methyl groups in the precursor (two per silicon atom) favor the formation of high densities of disilylmethylene groups (Si-CH₂-Si) in the as deposited film relative to precursors containing only one terminal methyl group per silicon atom. Presumably in the case of HMe₂SiOR the presence of the Si-H bond facilitates ready access to the two terminal methyl groups per silicon in the precursor and favors the formation of high densities of disilylmethylene groups (Si-CH₂-Si) in the as deposited film relative to precursors that contain ligands larger than a H atom.

Some of advantages of films made using hydrido-dimethyl-alkoxysilane compounds of Formula (1) over films made using prior art bis-alkoxysilane based silicon precursors include, but are not limited to:
- Lower Leakage Current Density at High Electric Field Strength
- High Electric Field at Breakdown
- Higher Resistance to Plasma Induced Damage
- Equivalent or Higher Mechanical Properties
- Higher Bridging SiCH₂Si Density
- Higher Percentage of the Total Carbon Content Comprised of Bridging SiCH₂Si Groups

The hydrido-dimethyl-alkoxysilanes having Formula 1 according to the present invention are preferably substantially free of halide ions. As used herein, the term "substantially free" as it relates to halide ions (or halides) such as, for example, chlorides (i.e. chloride-containing species such as HCl or silicon compounds having at least one Si-Cl bond) and fluorides, bromides, and iodides, means less than 5 ppm (by weight) measured by Ion chromatography (IC), preferably less than 3 ppm measured by IC, and more preferably less than 1 ppm measured by IC, and most preferably 0 ppm measured by IC. Chlorides are known to act as decomposition catalysts for the silicon precursor compounds having Formula (1). Significant levels of chloride in the final product can cause the silicon precursor compounds to degrade. The gradual degradation of the silicon precursor compounds may directly impact the film deposition process making it difficult for the semiconductor manufacturer to meet film specifications. In addition, the shelf-life or stability is negatively impacted by the higher degradation rate of the silicon precursor compounds thereby making it difficult to guarantee a 1-2 year shelf-life. Therefore, the accelerated decomposition of the silicon precursor compounds presents safety and performance concerns related to the formation of these flammable and/or pyrophoric gaseous byproducts. The hydrido-dimethyl-alkoxysilanes having Formula 1 are preferably substantially free of metal ions such as, Li⁺, Na⁺, K⁺, Mg²⁺, Ca²⁺, Al³⁺, Fe²⁺, Fe²⁺, Fe³⁺, Ni²⁺, Cr³⁺. As used herein, the term "substantially free" as it relates to Li, Na, K, Mg, Ca, Al, Fe, Ni, Cr means less than 5 ppm (by weight), preferably less than 3 ppm, and more preferably less than 1 ppm, and most preferably 0.1 ppm as measured by ICP-MS. In some embodiments, the silicon precursor compounds having Formula 1 are free of metal ions such as, Li⁺, Na⁺, K⁺, Mg²⁺, Ca²⁺, Al³⁺, Fe²⁺, Fe²⁺, Fe³⁺, Ni²⁺, Cr³⁺. As used herein, the term "free of" metal impurities as it relates to Li, Na, K, Mg, Ca, Al, Fe, Ni, Cr, means less than 1 ppm, preferably 0.1ppm (by weight) as measured by ICP-MS, most preferably 0.05 ppm (by weight) as measured by ICP-MS or other analytical method for measuring metals. In addition, the hydrido-dimethyl-alkoxysilanes having Formula 1 preferably have purity of 98 wt. % or higher, more preferably 99 wt. % or higher as measured by GC when used as precursor to deposit the silicon-containing films. Importantly the hydrido-dimethyl-alkoxysilanes having Formula 1 are preferably substantially free of oxygen-containing or nitrogen-containing impurities which are from either starting materials employed during synthesis or by-products generated during synthesis. Examples include, but not limited to, tetramethyldisiloxane, tetramethyldisilazane, organic amines such as trimethylamine, triethylamine, tri-n-butylamine, N,N-dimethylaniline, N,N-diethylaniline, pyridine, 4-methylpyridine, 3-methylpyridine, 2-methylpyridine, 2,6-dimethylpyridine, and any other organic amines used to promote the reaction. As used herein, the term "free of" oxygen-containing or nitrogen-containing impurities as it relates to tetramethyldisiloxane, tetramethyldisilazane, organic amines such as triethylamine, pyridine and any other organic amines, means 1000 ppm or less as measured by GC, preferably 500 ppm or less (by weight) as measured by GC, most preferably 100 ppm or less (by weight) as measured by GC or other analytical method for assay. The oxygen-containing impurities as defined herein are compounds having at least one oxygen atom and are either from staring materials or generated from the synthesis of hydrido-dimethyl-alkoxysilanes having Formula 1. Those oxygen-containing impurities may have close boiling point to the hydrido-dimethyl-alkoxysilanes having Formula 1, thus remaining in the product after purification. Likewise, the nitrogen-containing impurities as defined herein are compounds having at least one nitrogen atom and are either from the staring materials or generated from the synthesis of hydrido-dimethyl-alkoxysilanes. Those nitrogen-containing impurities may also have close boiling point to the hydrido-dimethyl-alkoxysilanes compounds having Formula I, thus remaining in the product after purification.

The low k dielectric films are organosilica glass ("OSG") films or materials. Organosilicates are employed in the electronics industry, for example, as low k materials. Material properties depend upon the chemical composition and structure of the film. Since the type of organosilicon precursor has a strong effect upon the film structure and composition, it is beneficial to use precursors that provide the required film properties to ensure that the addition of the needed amount of porosity to reach the desired dielectric constant does not produce films that are mechanically unsound. The method and composition described herein provide the means to generate low k dielectric films that have a desirable balance of electrical and mechanical properties as well as other beneficial film properties, such as a relatively low total carbon content, with a distribution of the type of carbon in the film that provides improved integration plasma resistance.

In certain embodiments of the method and composition described herein, a layer of silicon-containing dielectric material is deposited on at a least a portion of a substrate via a chemical vapor deposition (CVD) process employing a reaction chamber. The method thus includes the step of providing a substrate within a reaction chamber. Suitable substrates include, but are not limited to, semiconductor materials such as gallium arsenide ("GaAs"), silicon, and compositions containing silicon such as crystalline silicon, polysilicon, amorphous silicon, epitaxial silicon, silicon dioxide ("SiO₂"), silicon glass, silicon nitride, fused silica, glass, quartz, borosilicate glass, and combinations thereof. Other suitable materials include chromium, molybdenum, and other metals commonly employed in semiconductor, integrated circuits, flat panel display, and flexible display applications. The substrate may have additional layers such as, for example, silicon, SiO₂, organosilicate glass (OSG), fluorinated silicate glass (FSG), boron carbonitride, silicon carbide, hydrogenated silicon carbide, silicon nitride, hydrogenated silicon nitride, silicon carbonitride, hydrogenated silicon carbonitride, boronitride, organic-inorganic composite materials, photoresists, organic polymers, porous organic and inorganic materials and composites, metal oxides such as aluminum oxide, and germanium oxide. Still further layers can also be germanosilicates, aluminosilicates, copper and aluminum, and diffusion barrier materials such as, but not limited to, TiN, Ti(C)N, TaN, Ta(C)N, Ta, W, or WN.

The reaction chamber is typically, for example, a thermal CVD or a plasma enhanced CVD reactor or a batch furnace type reactor in a variety of ways. In one embodiment, a liquid delivery system may be utilized. In liquid delivery formulations, the precursors described herein may be delivered in neat liquid form, or alternatively, may be employed in solvent formulations or compositions comprising same. Thus, in certain embodiments the precursor formulations may include solvent component(s) of suitable character as may be desirable and advantageous in a given end use application to form a film on a substrate.

The method disclosed herein includes the step of introducing into the reaction chamber a gaseous composition comprising hydrido-dimethyl-alkoxysilane. In some embodiments, the composition may include additional reactants such as, for example, oxygen-containing species such as, for example, O₂, O₃, and N₂O, gaseous or liquid organic substances, alcohols, CO₂, or CO. In one particular embodiment, the reaction mixture introduced into the reaction chamber comprises the at least one oxidant selected from the group consisting of O₂, N₂O, NO, NO₂, CO₂, water, H₂O₂, ozone, and combinations thereof. In an alternative embodiment, the reaction mixture does not comprise an oxidant.

The composition for depositing the dielectric film described herein comprises from about 40 to about 100 weight percent of hydrido-dimethyl-alkoxysilane.

In embodiments, the gaseous composition comprising hydrido-dimethyl-alkoxysilane can be used with hardening additives to further increase the elastic modulus of the as deposited films.

In embodiments, the gaseous composition comprising hydrido-dimethyl-alkoxysilane is substantially free of or free of halides such as, for example, chlorides.

In addition to the hydrido-dimethyl-alkoxysilane, additional materials can be introduced into the reaction chamber prior to, during and/or after the deposition reaction. Such materials include, e.g., inert gas (e.g., He, Ar, N₂, Kr, Xe, etc., which may be employed as a carrier gas for lesser volatile precursors and/or which can promote the curing of the as-deposited materials and potentially provide a more stable final film if desired).

Any reagent employed, including the hydrido-dimethyl-alkoxysilane can be carried into the reactor separately from distinct sources or as a mixture. The reagents can be delivered to the reactor system by any number of means, preferably using a pressurizable stainless steel vessel fitted with the proper valves and fittings to allow the delivery of liquid to the process reactor. Preferably, the precursor is delivered into the process vacuum chamber as a gas, that is, the liquid must be vaporized before it is delivered into the process chamber.

The method disclosed herein includes the step of applying energy to the gaseous composition comprising hydrido-dimethyl-alkoxysilane in the reaction chamber to induce reaction of the gaseous composition comprising hydrido-dimethyl-alkoxysilane to deposit an organosilica film on the substrate, wherein the organosilica film has a dielectric constant of from ~ 2.70 to ~ 3.50 in some embodiments, 2.70 to 3.30 in other embodiments, and 2.80 to 3.20 in still preferred embodiments, an elastic modulus of from ~ 6 to ~ 36 GPa , and an at. % carbon of from ~ 10 to ~ 45 as measured by XPS. Energy is applied to the gaseous reagents to induce the hydrido-dimethyl-alkoxysilane and other reactants, if present, to react and to form the film on the substrate. Such energy can be provided by, e.g., plasma, pulsed plasma, helicon plasma, high density plasma, inductively coupled plasma, remote plasma, hot filament, and thermal (i.e., non-filament) methods. A secondary rf frequency source can be used to modify the plasma characteristics at the substrate surface. Preferably, the film is formed by plasma enhanced chemical vapor deposition ("PECVD").

The flow rate for each of the gaseous reagents preferably ranges from 10 to 5000 sccm, more preferably from 30 to 3000 sccm, per single 300 mm wafer. The actual flow rates needed may depend upon wafer size and chamber configuration, and are in no way limited to 300 mm wafers or single wafer chambers.

In certain embodiments, the film is deposited at a deposition rate of from about ~ 5 to ~ 400 nanometers (nm) per minute. In other embodiments, the film is deposited at a deposition rate of from about 30 to 200 nanometers (nm) per minute.

The pressure in the reaction chamber during deposition typically ranges from about 0.01 to about 600 torr or from about 1 to 15 torr.

The film is preferably deposited to a thickness of 0.001 to 500 microns, although the thickness can be varied as required. The blanket film deposited on a non-patterned surface has excellent uniformity, with a variation in thickness of less than 3% over 1 standard deviation across the substrate with a reasonable edge exclusion, wherein e.g., a 5 mm outermost edge of the substrate is not included in the statistical calculation of uniformity.

In addition to the inventive OSG products, the present invention includes the process by which the products are made, methods of using the products and compounds and compositions useful for preparing the products. For example, a process for making an integrated circuit on a semiconductor device is disclosed in U.S. Pat. No. 6,583,049.

The dense organosilica films produced by the disclosed methods exhibit excellent resistance to plasma induced damage, particularly during etch and photoresist strip processes.

The dense organosilica films produced by the disclosed methods exhibit excellent mechanical properties for a given dielectric constant relative to dense organosilica films having the same dielectric constant but made using a precursor that is not a monoalkoxysilane. The resulting organosilica film (as deposited) typically has a dielectric constant of from ~ 2.70 to ~ 3.50 in some embodiments, ~ 2.80 to ~ 3.20 in other embodiments, and ~ 2.70 to ~ 3.10 in still other embodiments, an elastic modulus of from ~ 6 to ~ 36 GPa , and an at. % carbon of from ~ 10 to ~ 45 as measured by XPS. In other embodiments, the resulting organosilica film has a dielectric constant of from ~ 2.70 to ~ 3.50 in some embodiments, ~ 2.80 to ~ 3.20 in other embodiments, and ~ 2.80 to ~ 3.10 in still other embodiments, an elastic modulus of from ~ 6 to ~ 36 GPa , and an at. % carbon of from ~ 12 to ~ 43 as measured by XPS. In some embodiments, the nitrogen content is 0.1 at. % or less, preferably 0.1 at. % or less, most preferably 0.01 at. % or less as measured by XPS or SIMS or RBS or any other analytical means. In some embodiments, as it is believed that incorporation of nitrogen could potentially increase the dielectric of dense organosilica films, thus it is expected that the nitrogen content is 0.1 at. % or less, preferably 0.1 at. % or less, most preferably 0.01 at. % or less as measured by XPS, SIMS or RBS or any analytical methods. In addition, the organosilica film has a relative disilylmethylene density from ~ 1 to ~ 30, or ~ 5 to ~ 30, or ~ 10 to ~ 30 or ~ 1 to ~ 20. It is expected that the organosilica film is deposited at a rate of from ~ 5 nm/min to ~ 2000 nm/min, or ~ 5 nm/min to ~ 1000 nm/min, or ~ 50 nm/min to ~ 1000 nm/min, or ~ 100 nm/min to ~ 2000 nm/min.

The resultant dense organosilica films may also be subjected to a post treating process once deposited. Thus, the term "post-treating" as used herein denotes treating the film with energy (e.g., thermal, plasma, photon, electron, microwave, etc.) or chemicals to further enhance materials properties.

The conditions under which post-treating are conducted can vary greatly. For example, post-treating can be conducted under high pressure or under a vacuum ambient.

UV annealing is a preferred method conducted under the following conditions.

The environment can be inert (e.g., nitrogen, CO₂, noble gases (He, Ar, Ne, Kr, Xe), etc.), oxidizing (e.g., oxygen, air, dilute oxygen environments, enriched oxygen environments, ozone, nitrous oxide, etc.) or reducing (dilute or concentrated hydrogen, hydrocarbons (saturated, unsaturated, linear or branched, aromatics), etc.). The pressure is preferably about 1 Torr to about 1000 Torr. However, a vacuum ambient is preferred for thermal annealing as well as any other post-treating means. The temperature is preferably 200-500 °C, and the temperature ramp rate is from 0.1 to 100 deg °C/min. The total UV annealing time is preferably from 0.01 min to 12 hours.

The invention will be illustrated in more detail with reference to the following Examples, but it should be understood that it is not deemed to be limited thereto. It is also recognized that the precursors described in this invention can also be used to deposit porous low k films with similar process advantages relative to existing porous low k films (that is a higher elastic modulus and greater resistance to plasma induced damage for a given value of the dielectric constant).

### EXAMPLES

All experiments were performed on a 300 mm AMAT Producer^{®} SE, which deposits films on two wafers at the same time. Thus, the precursor and gas flow rates correspond to the flow rates required to deposit films on two wafers at the same time. The stated RF power per wafer is correct, as each wafer processing station has its own independent RF power supply. The stated deposition pressure is correct, as both wafer processing stations are maintained at the same pressure. After deposition, some films were subjected to UV annealing. UV annealing was performed on a 300 mm AMAT Producer^{®} Nanocure^{™} UV cure module, with the wafer held under a helium gas flow at one or more pressures below 10 Torr and at one or more temperatures equal to or less than 400 °C.

Although illustrated and described above with reference to certain specific embodiments and examples, the present invention is nevertheless not intended to be limited to the details shown. Rather, various modifications may be made in the details within the scope and range of equivalents of the claims and without departing from the spirit of the invention. It is expressly intended, for example, that all ranges broadly recited in this document include within their scope all narrower ranges which fall within the broader ranges. It is also recognized that the hydrido-dimethyl-alkoxysilanes disclosed in this invention can be used as a structure former for the deposition of porous low k films with high mechanical strength, a strong resistance to plasma induced damage, a leakage current density, and a high breakdown voltage at a given value of the dielectric constant (k < 3.5).

Thickness and refractive index were measured on a Woollam model M2000 Spectroscopic Ellipsometer. Dielectric constants were determined using Hg probe technique on mid-resistivity p-type wafers (range 8-12 ohm-cm). FTIR spectra were measured using a Thermo Fisher Scientific Model iS50 spectrometer fitted with a nitrogen purged Pike Technologies Map300 for handling 12-inch wafers. FTIR spectra were used to calculate the relative density of bridging disilylmethylene groups in the film. The relative density of bridging disilylmethylene groups in the film (i.e., the SiCH₂Si density), as determined by infrared spectroscopy, was defined as 1E4 times the area of the SiCH₂Si infrared band centered near 1360 cm⁻¹ divided by the area of the SiOₓ bands between approximately 1250 cm⁻¹ to 920 cm⁻¹. Mechanical properties were determined using a KLA iNano Nano Indenter.

Compositional data were obtained by x-ray photoelectron spectroscopy (XPS) on either a PHI 5600 (73560, 73808) or a Thermo K-Alpha (73846) and are provided in atomic weight percent. The atomic weight percent (%) values reported in the table do not include hydrogen.

Blanket low k films were damaged by exposure to a capacitively coupled ammonia plasma in a TEOS/FSG chamber on an Applied Materials Producer^{®} SE. The process parameters used to damage the blanket low k films were the same for all blanket low k films: an ammonia flow rate = 900 standard cubic cm per min (sccm), a chamber pressure of 6.0 Torr, a pedestal temperature of 300 °C, an RF Power of 300 Watts (13.56 MHz), and an exposure time of 25 seconds.

Dynamic SIMS profiles were acquired using a continuous, focused beam of low energy Cs+ ions to remove material from the surface of the low k films by sputtering. Low energy Cs+ ions were used to reduce atomic mixing due to the collision cascades and to maximize depth resolution. Sputter rates were calibrated by sputtering down very close to the film-wafer interface and then measuring the sputtered depth with a stylus profilometer. RBS/HFS data of dense low k films similar to those being analyzed were used to quantify the SIMS profiles. The parameters used to acquire the dynamic SIMS depth profiles were the same for all plasma damaged low k films investigated.

For each precursor in the examples listed below the deposition conditions were optimized to yield films with high mechanical strength at the targeted dielectric constant.

### Comparative Example 1: Deposition of a Dense OSG Film from Diethoxymethylsilane (DEMS^{®}).

A dense DEMS^{®} based film was deposited using the following process conditions for 300 mm processing. The DEMS^{®} precursor was delivered to the reaction chamber via direct liquid injection (DLI) at a flow rate of 2500 mg/min using 1250 standard cubic centimeters per minute (sccm) He carrier gas flow, 25 sccm O₂, 380 milli-inch showerhead/heated pedestal spacing, 350 °C pedestal temperature, 7.5 Torr chamber pressure to which a 615 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Tables 1, 2, and 5.

### Comparative Example 2: Deposition of a Dense OSG Film from 1-Methyl-1-Isopropoxy-1-Silacyclopenane (MIPSCP).

A dense 1-methyl-1-isopropoxy-1-silacyclopenane (MIPSCP) based film was deposited using the following process conditions for 300 mm processing. The 1-methyl-1-isopropoxy-1-silacyclopenane precursor was delivered to the reaction chamber via direct liquid injection (DLI) at a flow rate of 850 mg/min using 750 standard cubic centimeters per minute (sccm) He carrier gas flow, 8 sccm O₂, 380 milli-inch showerhead/heated pedestal spacing, 390 °C pedestal temperature, 7.5 Torr chamber pressure to which a 275 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Tables 1 and 5.

### Comparative Example 3: Deposition of a Dense OSG Film from DEMS^{®}.

A dense DEMS^{®} based film was deposited using the following process conditions for 300 mm processing. The DEMS^{®} precursor was delivered to the reaction chamber via direct liquid injection (DLI) at a flow rate of 2000 mg/min using 1500 standard cubic centimeters per minute (sccm) He carrier gas flow, 25 sccm O₂, 380 milli-inch showerhead/heated pedestal spacing, 400 °C pedestal temperature, 7.5 Torr chamber pressure to which a 217 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Tables 3.

### Comparative Example 4: Deposition of a Dense OSG film from DEMS^{®}.

A dense DEMS^{®} based film was deposited using the following process conditions for 300 mm processing. The DEMS^{®} precursor was delivered to the reaction chamber via direct liquid injection (DLI) at a flow rate of 875 mg/min using 750 standard cubic centimeters per minute (sccm) He carrier gas flow, 90 sccm O₂, 380 milli-inch showerhead/heated pedestal spacing, 345 °C pedestal temperature, 10 Torr chamber pressure to which a 400 Watt 13.56 MHz plasma was applied. In some cases, the resulting film was then UV annealed. Various attributes of the as deposited and UV annealed films (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Table 6.

### Example 1: Deposition of a Dense OSG Film from Dimethyl-sec-butoxysilane (DMSBOS).

A dense dimethyl-sec-butyoxysilane based film was deposited using the following process conditions for 300 mm processing. The dimethyl-sec-butyoxysilane precursor was delivered to the reaction chamber via direct liquid injection (DLI) at a flow rate of 1289 mg/min using 975 standard cubic centimeters per minute (sccm) He carrier gas flow, O₂ = 53 sccm, 380 milli-inch showerhead/heated pedestal spacing, 400 °C pedestal temperature, 6.1 Torr chamber pressure to which a 390 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Tables 1, 4, and 5.

### Example 2: Deposition of a Dense OSG Film from Dimethyl-isoproxysilane (DMIPOS).

A dense dimethyl-isoproxysilane based film was deposited using the following process conditions for 300 mm processing. The dimethyl-isoproxysilane precursor was delivered to the reaction chamber via direct liquid injection (DLI) at a flow rate of 1100 mg/min using 750 standard cubic centimeters per minute (sccm) He carrier gas flow, O₂ = 40 sccm, 380 milli-inch showerhead/heated pedestal spacing, 400 °C pedestal temperature, 6.5 Torr chamber pressure to which a 400 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Tables 1 and 2.

### Example 3: Deposition of a Dense OSG Film from Dimethyl-tert-butoxysilane (DMTBOS).

A dense dimethyl-tert-butoxysilane based film was deposited using the following process conditions for 300 mm processing. The dimethyl-tert-butoxysilane precursor was delivered to the reaction chamber via direct liquid injection (DLI) at a flow rate of 1500 mg/min using 975 standard cubic centimeters per minute (sccm) He carrier gas flow, O₂ = 19 sccm, 380 milli-inch showerhead/heated pedestal spacing, 400 °C pedestal temperature, 6.7 Torr chamber pressure to which a 350 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Table 1.

### Example 4: Deposition of a Dense OSG Film from Dimethyl-sec-butoxysilane (DSBOS).

A dense dimethyl-sec-butoxysilane based film was deposited using the following process conditions for 300 mm processing. The dimethyl-sec-butoxysilane precursor was delivered to the reaction chamber via direct liquid injection (DLI) at a flow rate of 1200 mg/min using 975 standard cubic centimeters per minute (sccm) He carrier gas flow, O₂ = 45 sccm, 380 milli-inch showerhead/heated pedestal spacing, 400 °C pedestal temperature, 6.5 Torr chamber pressure to which a 390 Watt 13.56 MHz plasma was applied. In some cases, the resulting film was then UV annealed. Various attributes of the as deposited and UV annealed films (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Tables 2 and 6.

### Example 5: Deposition of a Dense OSG Film from Dimethyl-tert-butoxysilane (DMTBOS).

A dense dimethyl-tert-butoxysilane based film was deposited using the following process conditions for 300 mm processing. The dimethyl-tert-butoxysilane precursor was delivered to the reaction chamber via direct liquid injection (DLI) at a flow rate of 1300 mg/min using 975 standard cubic centimeters per minute (sccm) He carrier gas flow, O₂ = 19 sccm, 380 milli-inch showerhead/heated pedestal spacing, 400 °C pedestal temperature, 6.7 Torr chamber pressure to which a 425 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Table 2.

### Example 6: Deposition of a Dense OSG Film from Dimethyl-sec-butoxysilane (DSBOS).

A dense dimethyl-sec-butoxysilane based film was deposited using the following process conditions for 300 mm processing. The dimethyl-sec-butoxysilane precursor was delivered to the reaction chamber via direct liquid injection (DLI) at a flow rate of 1100 mg/min using 850 standard cubic centimeters per minute (sccm) He carrier gas flow, O₂ = 24 sccm, 380 milli-inch showerhead/heated pedestal spacing, 400 °C pedestal temperature, 7.0 Torr chamber pressure to which a 300 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Table 3.

### Example 7: Deposition of a Dense OSG Film from Dimethyl-tert-butoxysilane (DMTBOS).

A dense dimethyl-tert-butoxysilane based film was deposited using the following process conditions for 300 mm processing. The dimethyl-tert-butoxysilane precursor was delivered to the reaction chamber via direct liquid injection (DLI) at a flow rate of 1300 mg/min using 975 standard cubic centimeters per minute (sccm) He carrier gas flow, O₂ = 8 sccm, 380 milli-inch showerhead/heated pedestal spacing, 400 °C pedestal temperature, 6.7 Torr chamber pressure to which a 350 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Table 4.

### Example 8: Deposition of a Dense OSG Film from Dimethyl-iso-propoxysilane (DMIPOS).

A dense dimethyl-iso-propoxysilane based film was deposited using the following process conditions for 300 mm processing. The dimethyl-iso-propoxysilane precursor was delivered to the reaction chamber via direct liquid injection (DLI) at a flow rate of 1100 mg/min using 750 standard cubic centimeters per minute (sccm) He carrier gas flow, O₂ = 40 sccm, 380 milli-inch showerhead/heated pedestal spacing, 400 °C pedestal temperature, 6.5 Torr chamber pressure to which a 400 Watt 13.56 MHz plasma was applied. Various attributes of the film (e.g., dielectric constant (k), refractive index, elastic modulus and hardness, relative densities of Si(CH₃)ₓ and SiCH₂Si by infrared spectra, and atomic composition by XPS (atomic percent carbon, atomic percent oxygen, and atomic percent silicon)) were obtained as described above and are provided in Table 4.

### Example 9: Synthesis of Dimethyl-sec-butoxysilane and Other Hydrido-dimethyl-alkoxysilane precursors

214g (2.88mol) 2-butanol was added drop-wise to 300g (3.17mol) chlorodimethylsilane in 300mL pentane at reflux. A nitrogen purge was introduced to purge off HCl. After the addition was completed, refluxing was continued for 1 hour and then the reaction was left to cool to room temperature. Organoamine was added to drive the reaction to completion. The resulting reaction slurry was filtered and solvent was removed by distillation at atmospheric pressure. A vacuum distillation at 98°C /760 mmHg produced 175g of dimethylsec-butoxysilane with a purity of 99.5% as measured by GC. GC also shows some impurities such as tetramethyldisiloxane. The yield was 46%. Dimethyl-iso-propoxysilane (not part of the claimed subject-matter), dimethyl-tert-butoxysilane (not part of the claimed subject-matter), dimethyl-tert-pentoxysilane (not part of the claimed subject-matter), dimethyl-cyclopentoxysilane, and dimethyl-cyclohexoxysilane were made via similar fashion as Example 9 and were characterized by GC-MS. The molecular weight (MW), the structure, and corresponding major MS fragmentation peaks of each compound are provided below to confirm their identification.

| Chemical Name | Molecular Weight | Structure | MS |
|---|---|---|---|
| Dimethyl-iso-propoxysilane (not part of the claimed subject-matter) | 118.25 | 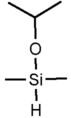 | 118, 103, 87, 75, 59, 43 |
| Dimethyl-sec-butoxysilane | 132.28 | 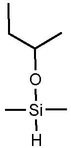 | 131, 117, 103, 87, 75, 59, 45 |
| Dimethyl-tert-butoxysilane (not part of the claimed subject-matter) | 132.28 | 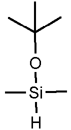 | 131, 117, 101, 87, 75, 59, 43 |
| Dimethyl-tert-pentoxysilane | 146.31 | 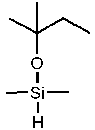 | 145, 131, 117, 101, 87, 75, 59, 43 |
| Dimethyl-cyclopentoxysilane (not part of the claimed subject-matter) | 144.29 | 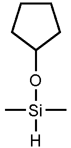 | 144, 129, 115, 101, 87, 75, 67, 61, 55, 41 |
| Dimethyl-cyclohexoxysilane | 158.32 | 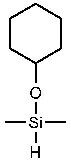 | 158, 143, 129, 115, 101, 87, 75, 59, 41 |

FIG. 1 provides an illustration of the predicted hardness and dielectric constant for a non-porous SiO₂ film in which increasing amounts of methyl groups have been added. The hardness may be predicted by applying the theory of Boolchand et al. (P. Boolchand, M. Zhang, B. Goodman, Phys. Rev. B, 53 11488, 1996) to methyl groups rather than atoms and examining the effect of terminal methyl groups on mechanical properties. The dielectric constant may be predicted via a group contribution method, which predicts the dielectric constant for polymers and for three-dimensionally connected amorphous materials. The hardness (assumed proportional to the elastic modulus) and dielectric constant can be normalized to that of hydroxyl-free silica, which as a dielectric constant of 3.8 and a modulus of 72 GPa. Using these values, FIG. 1 shows that the dielectric constant drops 19% when the C/Si ratio in the film is increased from 0 to approximately 0.6, with a corresponding 66% decrease in hardness. However, increasing the C/Si ratio further to 1 results in only an additional 4% decrease in dielectric constant, while the hardness approaches zero. Therefore, it is desirable to have a means of limiting the percentage of Si atoms substituted with terminal methyl groups as this may maximize the mechanical properties for a given dielectric constant. It is even more desirable to have a means of adding carbon to the film in the form of SiCH₂Si bridging groups. Incorporating carbon in the form of a bridging group is desirable because, from a mechanical strength point of view, the network structure is not disrupted by increasing the carbon content and higher mechanical strengths can be achieved relative to incorporating the same amount of carbon in the film in the form of terminal Si(CH₃)ₓ groups. Adding carbon to the film in the form of SiCH₂Si bridging groups also allows the film to be more resilient to carbon depletion of the OSG film from processes such as etching of the film, plasma ashing of photoresist, and NH₃ plasma treatment of copper surfaces. Carbon depletion in the OSG films can cause increases in the effective dielectric constant of the film, problems with film etching and feature bowing during wet cleaning steps, and/or integration issues when depositing copper diffusion barriers.

Table 1 shows that films made using the hydrido-dimethyl-alkoxysilane precursors described in this invention, DMSBOS, DMIPOS, and DMTBOS, as the structure former have equivalent or greater mechanical strength relative to films made using the DEMS^{®} structure former or the MIPSCP structure former at a similar dielectric constant. For example, the elastic modulus of the inventive DMSBOS based film is 60% greater than that of the comparative DEMS^{®} based film. Further, the films made using the hydrido-dimethyl-alkoxysilane precursors have a total carbon content, as measured by XPS, that is similar to films made using the DEMS^{®} structure former (~ 20 % C), but significantly less than the total carbon content of films made using the MIPSCP structure former (~ 34%). Most importantly, , the percentage of the total carbon in the film that is comprised of disilylmethylene groups, as defined by the ratio of the relative density of disilylmethylene groups as determined by IR spectroscopy to the value of total carbon content of the film as measured by XPS (for example, for DEMS^{®} Based, the ratio is 6/18 = 0.33), is much higher than those made using the DEMS^{®} structure former or the MIPSCP structure former, i.e. the ratio is greater than 0.65 for DMSBOS, DMIPOS, DMTBOS as shown in Table 1. Table 1 also illustrates that the film deposited using the DMSBOS structure former exhibits unique properties relative to the films deposited from the two other inventive hydrido-dimethyl-alkoxysilane compounds, DMIPOS and DMTBOS. The film deposited using the DMSBOS structure former has significantly higher mechanical properties relative to the films deposited from the DMIPOS and DMTBOS structure former precursors. For example, the elastic modulus and the hardness of the film deposited using the DMSBOS structure former are 14% greater and 41% greater, respectively, than the elastic modulus and hardness of the film deposited using the DMIPOS structure former. Similarly, the elastic modulus and the hardness of the film deposited using the DMSBOS structure former are 19% greater and 37% greater, respectively, than the elastic modulus and hardness of the film deposited using the DMTBOS structure former.

**Table 1. Comparative Film Properties for dense OSG films deposited using DEMS^{®}, MIPSCP, DMSBOS, DMIPOS, and DMTBOS.**

| Film | Dielectric Constant k | Elastic Modulus (GPa) | Hardness (GPa) | Total Carbon (at. % XPS) | Relative SiCH₂Si Density* | Relative SiCH₂Si Density*/ Total Carbon (at. % XPS) |
|---|---|---|---|---|---|---|
| DEMS^{®} Based | 3.0 | 15 | 2.2 | 18 | 6 | 0.33 |
| MIPSCP Based | 3.0 | 18 | 2.8 | 34 | 19 | 0.56 |
| DMSBOS Based | 3.1 | 24 | 3.7 | 19 | 16 | 0.84 |
| DMIPOS Based | 3.1 | 21 | 3.1 | 21 | 18 | 0.86 |
| DMTBOS Based | 3.0 | 17 | 2.7 | 20 | 16 | 0.80 |

| | | | | | | |
|---|---|---|---|---|---|---|
| *As determined by IR spectroscopy. | | | | | | |

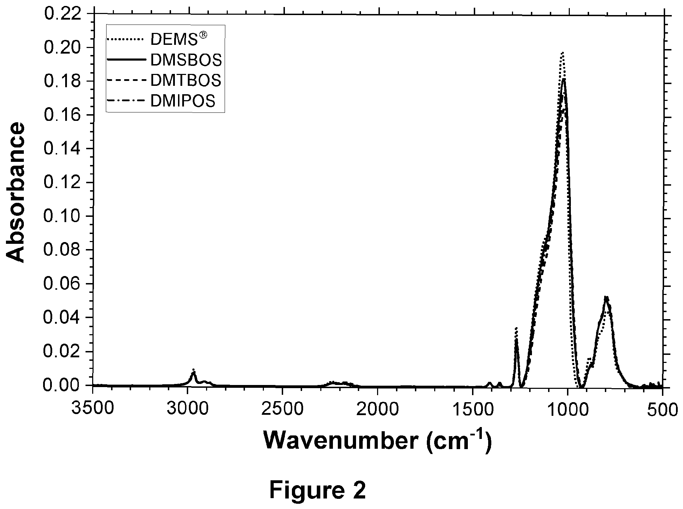

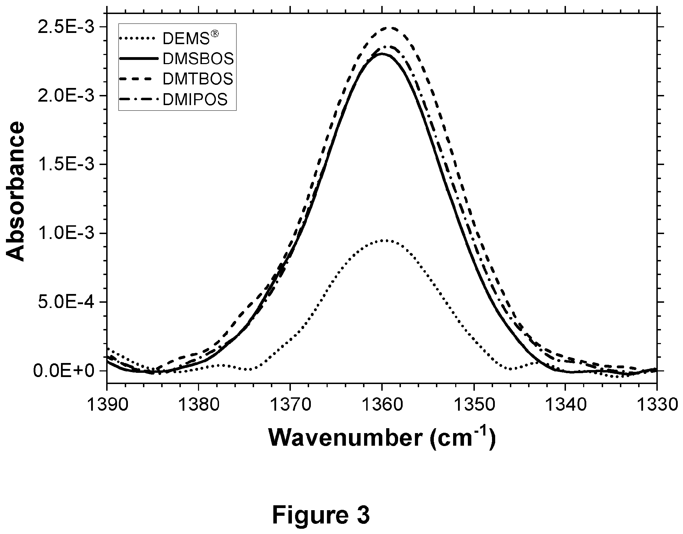

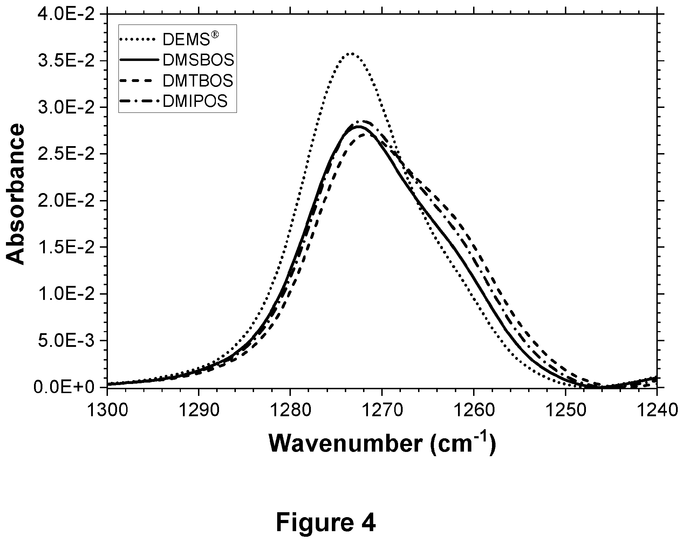

Transmission infrared spectra from 3500 cm⁻¹ to 500 cm⁻¹ are shown in Figure 2 for films made using the hydrido-dimethyl-alkoxysilane precursors described in this invention, DMSBOS, DMIPOS, and DMTBOS, as the structure former and for a film made using the DEMS^{®} structure former. All four films have a dielectric constant between 3.0 and 3.1 (Table 2). FIG. 3 shows an expanded image of the disilylmethylene (SiCH₂Si) infrared band centered near 1360 cm⁻¹ for all four films. The peak absorbance of the SiCH₂Si band for the films made using the DMSBOS, DMIPOS, and DMTBOS structure former precursors is at least two time greater than the peak absorbance of the SiCH₂Si band for the film made using the DEMS^{®} structure former precursor. FIG. 4 shows an expanded image of the terminal silicon methyl infrared bands (Si(CH₃)ₓ) centered near 1273 cm⁻¹ for all four films. The peak absorbance of the Si(CH₃)ₓ infrared bands for the films made using the DMSBOS, DMIPOS, and DMTBOS structure former precursors are between 20 and 24% smaller than the peak absorbance of the Si(CH₃)ₓ infrared band for the film made using the DEMS^{®} structure former precursor. Thus, the infrared spectra indicate that the films made using the DMSBOS, DMIPOS, and DMTBOS structure former precursors have a higher concentration of SiCH₂Si groups and a lower concentration of Si(CH₃)ₓ groups relative to films made using the DEMS^{®} structure former precursor.

The properties of the inventive and comparative dense OSG films in Figure 2 are given in Table 2. All four films have a dielectric constant between 3.0 and 3.1. As shown in Table 2, the relative SiCH₂Si densities (as determined from their infrared spectra) for films made using the inventive DMSBOS, DMIPOS, and DMTBOS structure forming precursors are 167% to 250% greater than the relative SiCH₂Si density of the film made using the DEMS^{®} structure former. Further insight into the unique carbon distribution in films made using the DMSBOS, DMIPOS, and DMTBOS structure forming precursors can be obtained by calculating the relative percentage of total carbon in these films that is comprised of disilylmethylene (SiCH₂Si) groups. The relative percentage of total carbon that is comprised of disilylmethylene (SiCH₂Si) groups can be calculated as the ratio of the Relative SiCH₂Si Density (determined by IR spectroscopy) to the Total Carbon Content in the film (as measured by XPS). As shown in Table 2, the relative percentage of total carbon that is comprised of disilylmethylene (SiCH₂Si) groups for films made using the inventive DMSBOS, DMIPOS, and DMTBOS structure forming precursors are 131% to 160% greater than the relative percentage of total carbon that is comprised of disilylmethylene (SiCH₂Si) groups of the film made using the DEMS^{®} structure former.

**Table 2. Film properties of the comparative and inventive dense OSG films shown in Figures 2, 3, and 4.**

| Parameter | DEMS^{®} Based Comparative Example 1 | DMSBOS Based Inventive Example 4 | DMTBOS Based Inventive Example 5 | DMIPOS Based Inventive Example 2 |
|---|---|---|---|---|
| Dielectric Constant | 3.0 | 3.1 | 3.1 | 3.1 |
| Elastic Modulus (GPa) | 15 | 24 | 21 | 21 |
| Hardness (GPa) | 2.2 | 3.9 | 3.2 | 3.1 |
| at. % Carbon (XPS) | 18 | 20 | 23 | 21 |
| at. % Oxygen (XPS) | 45 | 46 | 42 | 44 |
| at. % Silicon (XPS) | 37 | 34 | 35 | 35 |
| Relative SiCH₂Si Density* | 6 | 16 | 21 | 18 |
| Relative SiCH₂Si Density*/ Total Carbon (at. %XPS) | 0.33 | 0.81 | 0.91 | 0.86 |

| | | | | |
|---|---|---|---|---|
| *As determined by IR spectroscopy. | | | | |

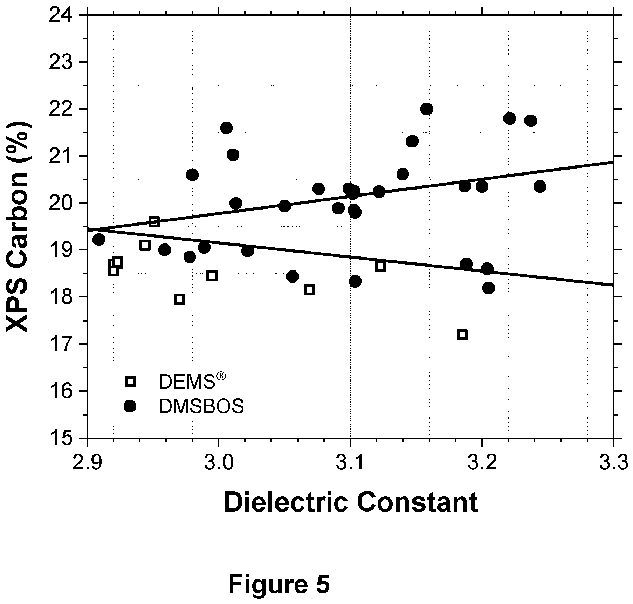

A series of depositions of dense low k dielectric films were deposited using either DMSBOS or DEMS^{®} as the low k precursor on a 300mm PECVD reactor under a variety of process conditions from 225-550 Watts plasma power, 5.5-10 Torr chamber pressure, 345-400 °C substrate temperature, 0-60 sccm O₂ gas flow, 750-2250 sccm He carrier gas flow, 0.750 to 2.500 g/min of precursor liquid flow, and a 0.380 inch electrode spacing. The atomic percentage of carbon was measured by XPS as described herein. Figure 5 shows the relationship between the XPS carbon content (atomic %) for dense OSG films made using DMSBOS and DEMS^{®} having different dielectric constants. As Figure 5 shows films made using the prior art precursor DEMS^{®} have a slightly lower, but similar, XPS carbon content to films made using the DMSBOS precursor at the same value of the dielectric constant as the dielectric constant is increased from about 2.9 to about 3.3. For both films the XPS carbon content falls within a relatively narrow range: ~ 19.5 ± 3%.

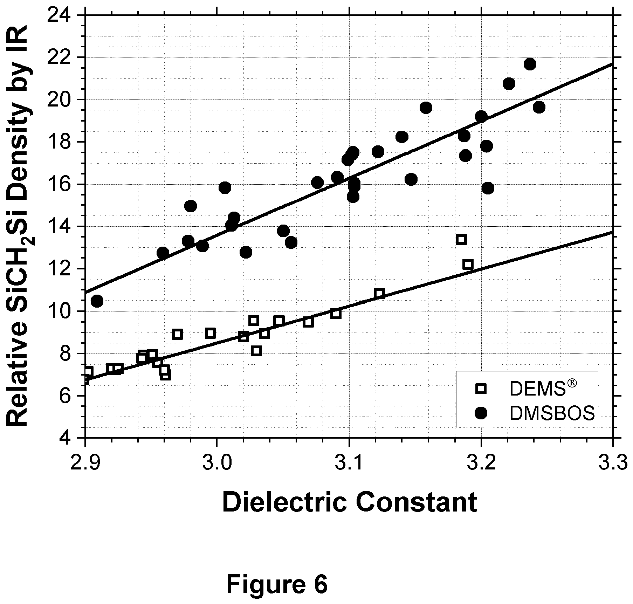

A series of depositions of dense low k dielectric films were deposited using either DMSBOS or DEMS^{®} as the low k precursor on a 300mm PECVD reactor under a variety of process conditions from 225-550 Watts plasma power, 5.5-10 Torr chamber pressure, 345-400 °C substrate temperature, 0-60 sccm O₂ gas flow, 750-2250 sccm He carrier gas flow, 0.750 to 2.500 g/min of precursor liquid flow, and a 0.380 inch electrode spacing. The density of SiCH₂Si groups was calculated from the infrared spectra for each film as described herein. Figure 6 shows the relationship between the density of the SiCH₂Si groups of dense OSG films made using the DMSBOS precursor and the DEMS^{®} precursor having different dielectric constants. As Figure 6 shows the prior art or DEMS^{®} low k films have a much lower density of SiCH₂Si groups at the same value of the dielectric constant relative to DMSBOS based films as the dielectric constant is increased from about 2.9 to about 3.3. This illustrates one of the important advantages of using hydrido-dimethyl-alkoxysilane compounds of Formula (1), for example, such as DMSBOS, for depositing a dense low k dielectric film which is for similar values of the dielectric constant, the hydrido-dimethyl-alkoxysilane precursor DMSBOS can be used to deposit films with a density of SiCH₂Si groups that is as high or higher than other prior art structure formers. In this manner, one can incorporate carbon in the form of a bridging group so that, from a mechanical strength view, the network structure is not disrupted by increasing the carbon content in the film. This also adds carbon to the film, allowing the film to be more resilient to carbon depletion from processes such as etching of the film, plasma ashing of photoresist, and NH₃ plasma treatment of copper surfaces. However, one of the unique attributes of films made using hydrido-dimethyl-alkoxysilane compounds of Formula (1), for example, such as DMSBOS, is that the total carbon content is rather low (< 25%) and the percentage of the total carbon content comprised of SiCH₂Si groups is high compared to prior art structure formers such as DEMS^{®} and MIPSCP.

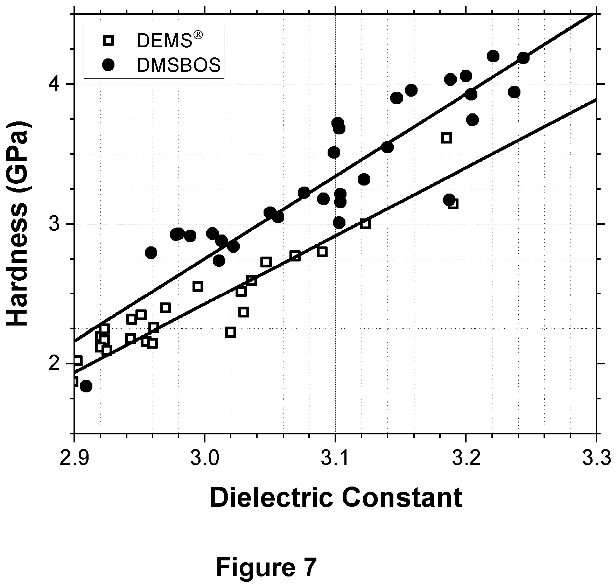

A series of depositions of dense low k dielectric films were deposited using either DMSBOS or DEMS^{®} as the low k precursor on a 300mm PECVD reactor under a variety of process conditions from 225-550 Watts plasma power, 5.5-10 Torr chamber pressure, 345-400 °C substrate temperature, 0-60 sccm O₂ gas flow, 750-2250 sccm He carrier gas flow, 0.750 to 2.500 g/min of precursor liquid flow, and a 0.380 inch electrode spacing. The hardness of the films was measured by nanoindentation as described herein. Figure 7 shows the relationship between the hardness of dense OSG films made using the DMSBOS precursor and the DEMS^{®} precursor having different dielectric constants. As Figure 7 shows the prior art or DEMS^{®} low k films have a lower hardness at the same value of the dielectric constant relative to DMSBOS based films as the dielectric constant is increased from about 2.9 to about 3.3. This illustrates one of the important attributes of using hydrido-dimethyl-alkoxysilane compounds of Formula (1), such as DMSBOS, versus other prior art structure formers to deposit a dense low k dielectric film which is for similar values of the dielectric constant, films deposited using the hydrido-dimethyl-alkoxysilane compounds of Formula (1), such as DMSBOS, can be used to deposit films with a hardness that is as high or higher relative to other prior art structure former precursors, even prior art structure formers specifically designed to deposit films with high mechanical properties, for example, such as the DEMS^{®} structure former precursor.

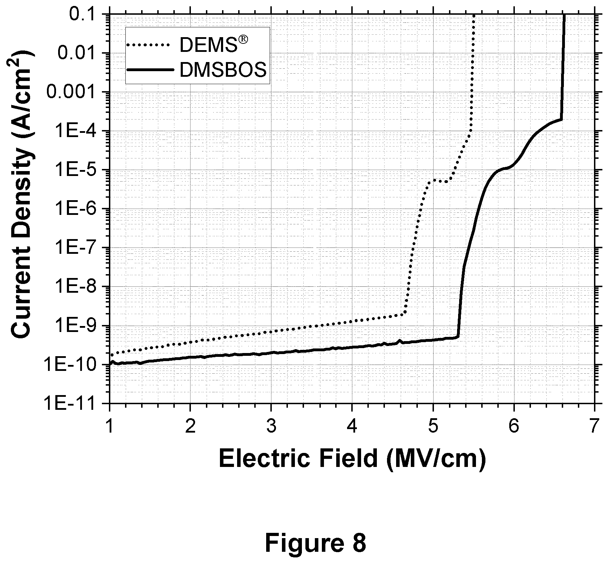

FIG. 8 shows the leakage current density for dense OSG films made using the DEMS^{®} structure former and from the DMSBOS structure former as a function of electric field strength from 1 MV/cm to 7 MV/cm. The electric field at breakdown is defined as a sudden rise in leakage current density of at least 2X. Thus, the electric field at breakdown of the film made using the DMSBOS precursor occurs at an electric field strength of 5.3 MV/cm, while the electric field at breakdown of the film made using the DEMS^{®} precursor occurs at an electric field strength of 4.6 MV/cm. A low dielectric constant film with the highest possible electric field at breakdown is preferred (> 4 MV/cm) for integrated circuit manufacturing since the breakdown field in device structures decreases as dimensions are decreased. Higher electric field strengths at breakdown are particularly important in the lowest levels of the BEOL where the small dimensions can result in high electrical field strengths. FIG. 8 illustrates that films made using hydrido-dimethyl-alkoxysilane compounds of Formula (1), such as DMSBOS, have a higher electric field at breakdown relative to films made using prior art structure formers such as DEMS^{®} and thus would be preferred for integrated circuit manufacturing. Low dielectric constant films with low leakage current densities result in increased reliability in integrated circuits. Low leakage current density is particularly important at high electric field strengths, ≥ 4 MV/cm, as device dimensions continue to shrink. As shown in FIG. 8, the leakage current density at an electric field strength of 4 MV/cm of the film made using the DMSBOS precursor is 0.27x10⁻⁹ A/cm², 78% lower than the leakage current density of the film made using the DEMS^{®} precursor at the same field strength (1.24x10⁻⁹ A/cm²). This example illustrates that films made using hydrido-dimethyl-alkoxysilane compounds of Formula (1), such as DMSBOS, have a lower leakage current density at high electric field strengths (≥ 4 MV/cm) relative to films made using prior art structure formers such as DEMS^{®} and thus would be preferred for integrated circuit manufacturing.

The properties of the two films shown in FIG. 8 are shown in Table 3. Both films have a dielectric constant of 3.0. The film made using the DMSBOS structure former has higher mechanical properties than the film made using the DEMS^{®} structure former, its elastic modulus and hardness being 27% and 48% greater than the film made using the DEMS^{®} structure former, respectively. The relative disilylmethylene (SiCH₂Si) density, as determined by IR spectroscopy, of the film made using the DMSBOS structure former is 260 % greater than the relative disilylmethylene density of the film made using the DEMS^{®} structure former. The percentage of the total carbon incorporated as disilylmethylene groups is 183% greater for the film made using the DMSBOS structure former relative to the film made using the DEMS^{®} structure former. Thus, films made using hydrido-dimethyl-alkoxysilane compounds of Formula (1), such as DMSBOS, have unique attributes that result in unique combination of favorable film properties: unexpectedly high mechanical properties, an unexpectedly high electric field at breakdown (≥ 5 MV/cm), and an unexpectedly low leakage current density at high electric field strengths (≥ 4 MV/cm) relative to films deposited from prior art low k structure formers such as DEMS^{®}. Not being bound by theory, these unique film properties are attributed to a unique distribution of carbon in these films; a relatively low total carbon content (< 25%), with a high density of disilylmethylene groups (> 10), and with a high percentage of the total carbon content being comprised of disilylemethylene groups (> 0.65). Such unique films can be deposited using the inventive hydrido-dimethyl-alkoxysilane compounds described in Formula (1), for example, such as DMSBOS.

**Table 3. Film properties of the comparative and inventive dense OSG films shown in Figure 8.**

| Parameter | DEMS^{®} Based Comparative Example 3 | DMSBOS Based Inventive Example 6 |
|---|---|---|
| Dielectric Constant | 3.0 | 3.0 |
| Elastic Modulus (GPa) | 15 | 19 |
| Hardness (GPa) | 2.1 | 3.1 |
| at. % Carbon (XPS) | > 17** | 22 |
| at. % Oxygen (XPS) | Not Collected | 43 |
| at. % Silicon (XPS) | Not Collected | 35 |
| Relative SiCH₂Si Density* | 5 | 18 |
| Relative SiCH₂Si Density*/ Total Carbon (at. % XPS) | < 0.29 | 0.82 |
| Leakage Current Density at 4 MV/cm (x10⁻⁹ A/cm²) | 1.24 | 0.27 |
| Electric Field at Breakdown (MV/cm) | 4.6 | 5.3 |

| | | |
|---|---|---|
| *As determined by IR spectroscopy. ** Estimated from Figure 5. | | |

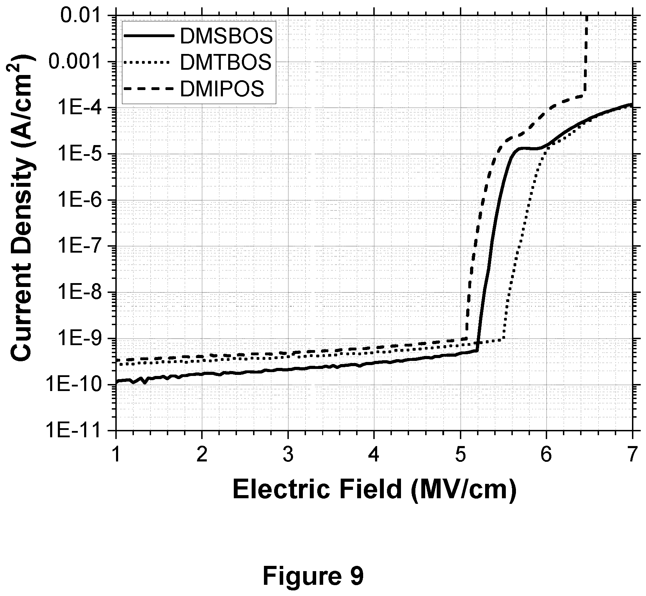

FIG. 9 shows the leakage current density for dense OSG films made using three different inventive hydrido-dimethyl-alkoxysilane compounds, DMIPOS, DMSBOS, and DMTBOS, as a function of electric field strength from 1 MV/cm to 7 MV/cm. All three films have an unexpectedly high electric field at breakdown of > 5 MV/cm. Further, all three films have an unexpectedly low leakage current density at 4 MV/cm of less than 1x10⁻⁹ A/cm². FIG. 9 also illustrates that the film deposited using the DMSBOS structure former exhibits unique properties relative to the films deposited from the two other inventive hydrido-dimethyl-alkoxysilane compounds, DMIPOS and DMTBOS. The film deposited using the DMSBOS structure former has a lower leakage current density at high field strength (> 4 MV/cm) relative to the films deposited from the DMIPOS and DMTBOS structure former precursors.

The properties of the three dense OSG films made using the inventive DMIPOS, DMSBOS, and DMTBOS structure former precursors are shown in Table 4. The dielectric constant of all three films is similar, ranging from 3.1 to 3.2. All three films have mechanical properties as high or higher than films deposited from prior are low k structure formers designed to result in films with high mechanical strength, for example, such as DEMS^{®}, at the same value of the dielectric constant (for example, see the film properties of films deposited using the DEMS^{®} structure former in Tables 3 and 7). Further, all three dense OSG films made using the DMIPOS, DMSBOS, and DMTBOS structure former precursors have high densities of disilylmethylene (SiCH₂Si) groups (> 10) relative to films deposited using the DEMS^{®} structure former precursor. Further, the three dense OSG films made using the DMIPOS, DMSBOS, and DMTBOS structure former precursors all have a high percentage of their total carbon content comprised of disilylmethylene (SiCH₂Si) groups (> 0.65) relative to films deposited using the DEMS^{®} structure former precursor. Thus, films made using hydrido-dimethyl-alkoxysilane compounds of Formula (1), such as DMIPOS, DMSBOS, and DMTBOS, have unique attributes that result in an unexpectedly high mechanical properties, an unexpectedly high electric field at breakdown (≥ 5 MV/cm), and an unexpectedly low leakage current density at high electric field strengths (≥ 4 MV/cm) relative to films deposited from prior art low k structure formers such as DEMS^{®}. Not being bound by theory, these unique film properties are attributed to a unique distribution of carbon in these films; a relatively low total carbon content (< 25%), with a high density of disilylmethylene groups (> 10), and with a high percentage of the total carbon content being comprised of disilylemethylene groups (> 0.65). Further, the film deposited using the DMSBOS structure former exhibits unique properties relative to the films deposited from the two other inventive hydrido-dimethyl-alkoxysilane compounds, DMIPOS and DMTBOS. Specifically, the film deposited using the DMSBOS structure former has a lower leakage current density at high field strength (> 4 MV/cm) relative to the films deposited from the DMIPOS and DMTBOS structure former precursors.

**Table 4. Film properties of the inventive dense OSG films shown in Figure 9.**

| Parameter | DMSBOS Based Inventive Example 1 | DMTBOS Based Inventive Example 7 | DMIPOS Based Inventive Example 8 |
|---|---|---|---|
| Dielectric Constant | 3.1 | 3.2 | 3.2 |
| Elastic Modulus (GPa) | 24 | 24 | 21 |
| Hardness (GPa) | 3.7 | 3.9 | 3.2 |
| at. % Carbon (XPS) | 19 | 23 | 20 |
| at. % Oxygen (XPS) | 47 | 42 | 45 |
| at. % Silicon (XPS) | 34 | 35 | 35 |
| Relative SiCH₂Si Density* | 16 | 23 | 17 |
| Relative SiCH₂Si Density*/Total Carbon (at. % XPS) | 0.84 | 1.0 | 0.85 |
| Leakage Current Density at 4 MV/cm (x 10⁻⁹ A/cm²) | 0.29 | 0.55 | 0.63 |
| Electric Field at Breakdown (MV/cm) | 5.2 | 5.5 | 5.1 |

| | | | |
|---|---|---|---|
| *As determined by IR spectroscopy. | | | |

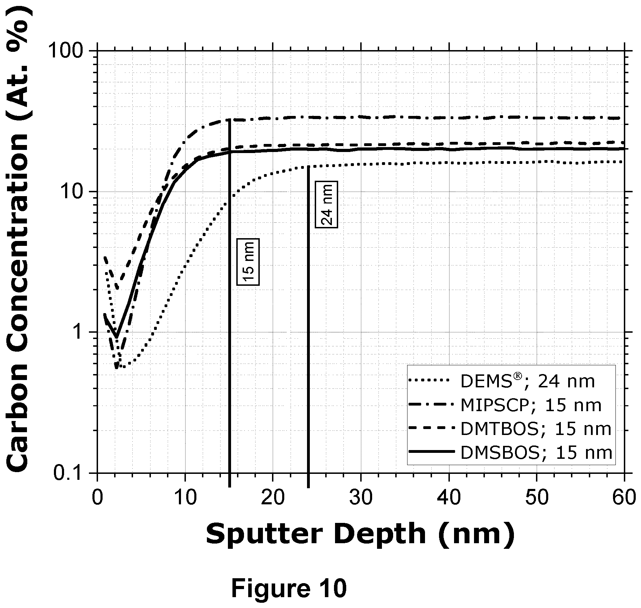

FIG. 10 shows the dynamic SIMS profiles of comparative film 1 (deposited using the DEMS^{®} structure former), comparative film 2 (deposited using the MIPSCP structure former), inventive film 1 (deposited using the DMSBOS structure former), and inventive film 5 (deposited using the DMTBOS structure former) after the films were damaged using an NH₃ plasma. All four films were exposed to a 25 second NH₃ plasma at 300 W plasma power to model the plasma damage conditions seen in integration. The depth of carbon removal (also denoted as the depth of plasma induced damage) is indicated by the depth to which the carbon was removed from the film as indicated by the dynamic SIMS depth profiling.

The properties of the four films in FIG. 10 are shown in Table 5. The dielectric constants of the films are between 3.0 and 3.1. The mechanical strength of the films deposited using the hydrido-dimethyl-alkoxysilane structure former precursors, DMSBOS and DMTBOS, is much greater than the mechanical strength of the films deposited using the prior art structure formers precursors DEMS^{®} and MIPSCP. The relative SiCH₂Si density, as determined by IR spectroscopy, of the films deposited using the DMSBOS, DMTBOS, and MIPSCP structure former precursors are all high (> 10), while the relative SiCH₂Si density of the film deposited using the DEMS^{®} structure former precursor is low (6). The film deposited using the prior art structure former MIPSCP has both the highest total carbon content, as determined from its SIMS depth profile (atomic % carbon = 34 %), and the highest relative SiCH₂Si density (19). Similarly, the film deposited using the prior art structure former DEMS^{®} has the lowest total carbon content, as determined from its SIMS depth profile (atomic % carbon = 16 %), and the lowest SiCH₂Si density (6). The percentage of total carbon that is comprised of SiCH₂Si groups, as defined in Table 5, is greatest for the films deposited using the DMSBOS and DMTBOS structure former precursors and smallest for films deposited using the prior art structure formers DEMS^{®} and MIPSCP.

**Table 5. Film properties of the comparative and inventive dense OSG films shown in Figure 10.**

| Parameter | DEMS^{®} Based Comparative Example 1 | MIPSCP Based Comparative Example 2 | DMSBOS Based Inventive Example 1 | DMTBOS Based Inventive Example 5 |
|---|---|---|---|---|
| Dielectric Constant | 3.0 | 3.0 | 3.1 | 3.1 |
| Elastic Modulus (GPa) | 15 | 18 | 24 | 21 |
| Hardness (GPa) | 2.2 | 2.8 | 3.7 | 3.2 |
| Relative SiCH₂Si Density* | 6 | 19 | 16 | 18 |
| Relative SiCH₂Si Density*/ Total Carbon (at. % XPS) | 0.33 | 0.56 | 0.84 | 0.91 |
| Depth of Carbon Removal or Depth of Plasma Induced Damage (nm) | 24 | 15 | 15 | 15 |

| | | | | |
|---|---|---|---|---|
| *As determined by IR spectroscopy. | | | | |

It is well established that the resistance to carbon removal from a dielectric film increases as the total carbon content of the film increases. For example, to the best of our knowledge films made using the prior art precursor MIPSCP, or its derivatives, for example, such as 1-methyl-1-ethoxy-1-silacyclopentane or MIPSCP, have the strongest resistance to carbon removal when exposed to an NH₃ plasma of any have dense low k film deposited to date (U.S. patent 9,922,818). This is attributed to the very high carbon content of these films (typically > 30%). This is illustrated in U.S. patent 9,922,818 where the depth of carbon removal following exposure to a NH₃ plasma for a low k film made using a combination of the MIPSCP structure former precursor and cyclooctane containing 36% carbon (XPS, atomic %) is 20% less (35 nm compared to 44 nm) than a low k film made using a combination of the DEMS^{®} structure former precursor and cyclooctane containing 23% carbon (XPS, atomic %). It has also been reported that the resistance to carbon removal from a dielectric film increases as the concentration of bridging SiCH₂Si groups in the film increases. Thus, for the four films listed in Table 5 the film deposited using the MIPSCP structure former precursor should have the greatest resistance to carbon removal when exposed to an NH₃ plasma while the film deposited using the DEMS^{®} structure former precursor should have the least resistance to carbon removal when exposed to an NH₃ plasma.

The depth of carbon removal after exposure to an NH₃ plasma is approximately 15 nm, as determined by SIMS depth profiling, for the films made using the DMSBOS, DMTBOS, and MIPSCP structure former precursors, while the depth of carbon removal after exposure to an NH₃ plasma for the film made using the DEMS^{®} structure former precursor is much higher, approximately 24 nm. The high depth of carbon removal for the film made using the DEMS^{®} structure former precursor is expected as this film has the lowest total carbon content and the lowest density of SiCH₂Si groups. Unexpectedly, the depth of carbon removal from the film made using MIPSCP is not the smallest, even though the MIPSCP based film has the greatest carbon content (34 atom % carbon as determined from its SIMS depth profile) and the highest density of SiCH₂Si groups (relative SiCH₂Si density by IR = 19). More surprisingly, the two films made using hydrido-dimethyl-alkoxysilane compounds described in Formula (1), for example, DMSBOS and DMTBOS, have the same small depth of carbon removal, as determined by SIMS depth profiling, as the film made using the prior art MIPSCP structure former. This is quite unexpected, as the films made using the DMSBOS and DMTBOS structure former compounds have both a lower total carbon content (41% and 38% less carbon, respectively), as determined from their SIMS depth profiles, and a lower density of SiCH₂Si groups (16% and 5% less, respectively) relative to the film made using the MIPSCP structure former. This is another unique attribute of films made using hydrido-dimethyl-alkoxysilane compounds described in Formula (1), for example, such as DMSBOS and DMTBOS, which is that films made using hydrido-dimethyl-alkoxysilane compounds described in Formula (1) have a much higher resistance to carbon removal when exposed to an NH₃ plasma than expected for films with a relatively low total carbon content (< ~ 25 atomic %). Not being bound by theory, this unique film property is attributed to a unique distribution of carbon in these films; a relatively low total carbon content (< 25%), with a high density of disilylmethylene groups (> 10, as determined by IR spectroscopy), and with a high percentage of the total carbon content being comprised of disilylmethylene groups (> 0.65, as determined by a combination of IR spectroscopy and XPS). To illustrate, the films made using the DMSBOS and DMTBOS structure former precursors in Table 5 both have the highest percentage of the total carbon content comprised of disilylmethylene groups (0.84 and 0.91, respectively) relative to the films made using the prior art structure formers MIPSCP (0.56) and DEMS^{®} (0.33). Indeed, the prior art structure former MIPSCP was specifically designed to deposit films with a high percentage of carbon to provide strong resistance to carbon removal after exposure to an NH₃ plasma. While this film does contain a high percentage of total carbon (34 atomic %, as measured from its SIMS depth profile) and a high density of SiCH₂Si groups as determined by its infrared spectra, it also contains high densities of other forms of carbon, such as terminal methyl groups. Thus, while a higher total carbon content in a low k dielectric film can provide a high resistance to carbon removal when exposed to an NH₃ plasma, the type of carbon in the film also plays a significant role. Specifically, as shown in FIG. 10 and Table 5, films with a relatively low total carbon content (< 25%), a high density of disilylmethylene groups (> 10, as determined by IR spectroscopy), and a high percentage of the total carbon content being comprised of disilylemethylene groups (> 0.65, as determined from a combination of IR spectroscopy and XPS) exhibit a resistance to carbon removal upon exposure to an NH₃ plasma that is the same as films with a much higher total carbon content made using prior art structure former precursors, for example, such as MIPSP; structure former precursors specifically that were designed to provide a high resistance to carbon removal when exposed to an NH₃ plasma.

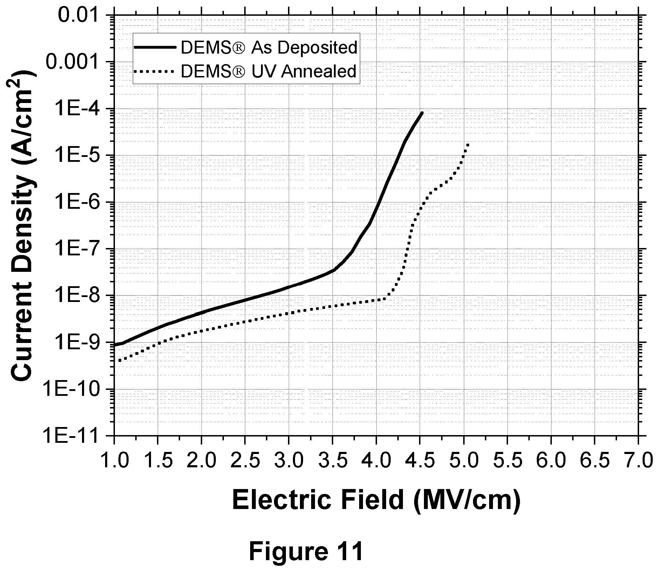

FIG. 11 shows the leakage current density of dense OSG films made using the DEMS^{®} structure former precursor (comparative example 4) both before and after UV annealing as a function of electric field strength from 1 MV/cm to 7 MV/cm. The properties of the dense OSG films made using the DEMS^{®} structure former both before and after UV annealing are shown in Table 6. The as deposited film has an electric field at breakdown of 3.5 MV/cm and a high leakage current density of 259x10⁻⁹ A/cm² at a field strength of 4 MV/cm. After UV annealing, the film has an electric field at breakdown of 4.2 MV/cm and a leakage current density of 7.9x10⁻⁹ A/cm² at a field strength of 4 MV/cm. Thus, for comparative example 4, as shown in FIG. 11, UV annealing increases the electric field at breakdown (+20%) and decreases the leakage current density (97% less at a field strength 4 MV/cm). The electrical behavior of the film made using the structure former precursor DEMS^{®} in FIG. 11 is representative of films made using prior art structure formers. Films made using a single structure former precursor have been reported to result in high leakage current density. Further, low leakage current density depends on post deposition treatments, such as UV annealing. To illustrate, it has been reported that as deposited low k films always have a higher leakage current density than the same film following UV annealing. This is a significant limitation of dense OSG films deposited from a single structure former precursor, as UV annealing increases equipment cost, process complexity, reduces throughput, and decreases a films resistance to plasma induced damage.

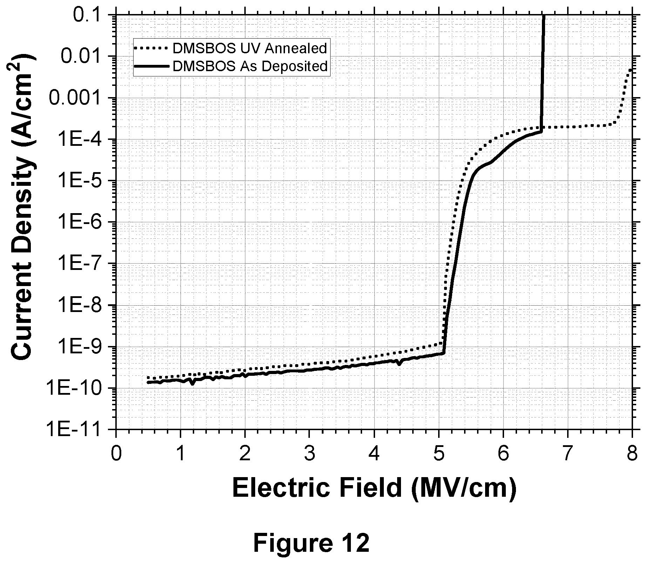

**Table 6. Film properties of the comparative and inventive dense OSG films shown in Figures 11 and 12.**

| Parameter | DEMS^{®} Based Comparative Example 4 | DEMS^{®} Based Comparative Example 4, UV Annealed | DMSBOS Based Inventive Example 4 | DMSBOS Based Inventive Example 4, UV Annealed |
|---|---|---|---|---|
| Dielectric Constant | 3.2 | 2.9 | 3.1 | 3.2 |
| Elastic Modulus (GPa) | 16 | Not Collected | 24 | 27 |
| Hardness (GPa) | 2.4 | Not Collected | 3.9 | 3.9 |
| at. % Carbon (XPS) | 12 | Not Collected | 20 | 19 |
| at. % Oxygen (XPS) | 53 | Not Collected | 46 | 47 |
| at. % Silicon (XPS) | 35 | Not Collected | 34 | 35 |
| Relative SiCH₂Si Density* | 4 | 4 | 16 | 18 |
| Relative SiCH₂Si Density*/ Total Carbon (at. % XPS) | 0.33 | Not Collected | 0.80 | 0.95 |
| UV Anneal Time (min) | 0 | 6 | 0 | 8 |
| Leakage Current Density at 4 MV/cm (x10⁻⁹ A/cm²) | 259 | 7.90 | 0.39 | 0.57 |
| Electric Field at Breakdown (MV/cm) | 3.5 | 4.2 | 5.1 | 5.1 |

| | | | | |
|---|---|---|---|---|
| *As determined by IR spectroscopy. | | | | |

FIG. 12 shows the leakage current density of dense OSG films made using the inventive DMSBOS structure former precursor (inventive example 4) both before and after UV annealing as a function of electric field strength from 1 MV/cm to 7 MV/cm. The properties of the dense OSG films made using the DMSBOS structure former both before and after UV annealing are shown in Table 6. Both the as deposited film and UV annealed films have an electric field at breakdown of 5.1 MV/cm. That is, UV annealing has no impact on the electric field at breakdown. There is also very little difference in the leakage current density between the as deposited film and the UV annealed film. For example, at a field strength of 4 MV/cm the leakage current density of the as deposited film is 0.39x10⁻⁹ A/cm² and after UV annealing the leakage current density of the film is 0.57x10⁻⁹ A/cm². Even though there is a small increase in the leakage current density after UV curing, the leakage current density is still low (< 1x10⁻⁹ A/cm²) at high field strengths (≥ 4 MV/cm). This illustrates another unique attribute of films made using hydrido-dimethyl-alkoxysilane compounds described in Formula (1), for example, such as DMSBOS, which is that as deposited films made using hydrido-dimethyl-alkoxysilane compounds described in Formula (1) have a low leakage current density (< 1x10⁻⁹ A/cm²) at a high electric field strength (≥ 4 MV/cm) and a high electric field at breakdown (≥ 5 MV/cm) with the need for post deposition steps, such as UV annealing. That is, the desired electrical film properties are observed in as deposited films from hydrido-dimethyl-alkoxysilane compounds described in Formula (1) without the need for UV annealing.

Thus, the hydrido-dimethyl-alkoxysilane compounds given in Formula (1) fulfill an urgent need for dense as deposited low k materials in integrated circuit manufacturing, particularly for lowest levels in the back end of the line. Hydrido-dimethyl-alkoxysilane compounds given in Formula (1), such as, for example, DMSBOS, DMIPOS, and DMTBOS, are volatile structure former low k precursors that can be used to deposit dense low k films with high mechanical strength, a strong resistance to plasma induced damage, a leakage current density of less than 1x10⁻⁹ A/cm² at high field strengths (≥ 4 MV/cm), and a high breakdown voltage (> 5 MV/cm) at a given value of the dielectric constant (k ≤ 3.5). These precursors have a high vapor pressure (low molecular weight), facilitating delivery into the reaction chamber as a gas phase reagent without condensing in the vapor delivery line or the process pump exhaust. Further, the films deposited from such precursors do not require post deposition treatment, such as UV curing, to improve the films mechanical properties or the films electrical properties. That is, the intrinsic properties of their as deposited film should meet the requirements for integrated circuit manufacturing such that post deposition steps (i.e., UV curing) are not needed. Further, the DMSBOS structure former precursor exhibits unique attributes within the class of hydrido-dimethyl-alkoxysilane compounds given in Formula (1). Specifically, films deposited using the DMSBOS structure former precursor have the highest mechanical properties and the lowest leakage current density at high electric fields (4 MV/cm) relative to other films deposited using hydrido-dimethyl-alkoxysilane compounds given in Formula (1), for example, such as DMIPOS and DMTBOS.

## Claims

1. A method for depositing an organosilica film, the method comprising:
providing a substrate within a reaction chamber;
introducing into the reaction chamber a gaseous composition comprising a hydrido-dimethyl-alkoxysilane having the structure given in Formula (1):
(1) H(Me)₂SiOR
wherein R is selected from the group consisting of iso-propyl, sec-butyl, tert-butyl, 2-pentyl, 3-pentyl, 3-methyl-2-butyl, tert-pentyl, cyclopentyl, and cyclohexyl; and
applying energy to the gaseous composition in the reaction chamber to induce a reaction of the hydrido-dimethyl-alkoxysilane and thereby deposit the organosilica film on the substrate.

2. The method of claim 1, wherein the composition comprising the hydrido-dimethyl-alkoxysilane of Formula (1) is substantially free, meaning less than 5 ppm (by weight) measured by ion chromatography (IC), of one or more impurities selected from the group consisting of halide compounds, water, metals, oxygen-containing impurities, nitrogen-containing impurities and combinations thereof.

3. The method of claim 1, wherein the organosilica film has a dielectric constant of from ~ 2.70 to ~ 3.50, an elastic modulus of from ~ 6 to ~ 36 GPa, and an XPS carbon content of from ~ 10 to ~36 at. %.

4. The method of claim 1 wherein the gaseous composition comprising hydrido-dimethyl-alkoxysilane is free of a hardening additive.

5. The method of claim 1 which is a chemical vapor deposition method or
a plasma enhanced chemical vapor deposition method.

6. The method of claim 1 wherein the gaseous composition comprising hydrido-dimethyl-alkoxysilane further comprises the at least one oxidant selected from the group consisting of O₂, N₂O, NO, NO₂, CO₂, CO, water, H₂O₂, ozone, alcohols, and combinations thereof.

7. The method of claim 1 wherein the gaseous composition comprising hydrido-dimethyl-alkoxysilane does not comprise an oxidant.

8. The method of claim 1 wherein the reaction chamber during the applying step comprises at least one gas selected from the group consisting of He, Ar, N₂, Kr, Ne, and Xe.

9. The method of claim 8, wherein the reaction chamber during the applying step further comprises at least one oxidant selected from the group consisting of O₂, N₂O, NO, NO₂, CO₂, CO, water, H₂O₂, ozone, alcohols, and combinations thereof.

10. The method of claim 1 wherein the organosilica film has a refractive index (RI) of from ~ 1.3 to ~ 1.7 at 632 nm.

11. The method of claim 1 wherein the organosilica film is deposited at a rate of from ~ 5 nm/min to ~ 400 nm/min.

12. The method of claim 1, wherein the organosilica film has a value of relative bridging methylene (SiCH₂Si) density as determined by IR spectrscopy of ~ 10 to ~30, and further has a ratio of relative SiCH₂Si Density*/ total carbon (at. % XPS) is greater than ~ 0.65.

13. The method of claim 1, wherein the organosilica film has a value of the leakage current density of less than 1 x 10⁻⁹ A/cm² at an electric field strength greater than or equal to 4 MV/cm.

14. The method of claim 1, wherein R is sec-butyl.

15. The method of claim 1 wherein the organosilica film has a refractive index (RI) of from ~ 1.3 to ~ 1.6 at 632 nm and a nitrogen content of 0.1 at. % or less as measured by XPS or SIMS or RBS.

16. A composition for a vapor deposition of a dielectric film **characterised in that** it comprises a hydrido-dimethyl-alkoxysilane having the structure given in Formula (1):
(1) H(Me)₂SiOR
wherein R is selected from the group consisting of sec-butyl, 2- pentyl, 3-pentyl, 3-methyl-2-butyl, tert-pentyl, and cyclohexyl.

17. The composition of claim 16, wherein the composition is substantially free, meaning less than 5 ppm (by weight) measured by ion chromatography (IC), of one or more impurities selected from the group consisting of halide compounds, water, oxygen-containing impurities, nitrogen-containing impurities, and metals.

18. The composition of claim 16, wherein the composition is substantially free of chloride compounds.

19. The composition of claim 18, wherein the chloride compounds, if present, are present at a concentration of 10 ppm or less as measured by IC or
wherein the chloride compounds, if present, are present at a concentration of 5 ppm or less as measured by IC or
wherein the chloride compounds, if present, are present at a concentration of 1 ppm or less as measured by IC.

20. The composition of claim 16, wherein the composition is substantially free of nitrogen-containing impurities.

21. The composition of claim 20, wherein the nitrogen-containing impurities, if present, are present at a concentration of ~1000 ppm or less as measured by GC or
wherein the nitrogen-containing impurities, if present, are present at a concentration of ~500 ppm or less as measured by GC.

22. The composition of claim 16, which comprises dimethyl-tert-pentoxysilane or which comprises dimethyl-2-pentoxysilane.

23. A compound of dimethyl-sec-butoxysilane.

## Patentansprüche

1. Verfahren zum Abscheiden eines Organosilicafilms, das Verfahren umfassend:
Bereitstellen eines Substrats in einer Reaktionskammer;
Einleiten einer gasförmigen Zusammensetzung, die ein Hydrido-Dimethyl-Alkoxysilan mit der in Formel (1) angegebenen Struktur umfasst, in die Reaktionskammer:
(1) H(Me)₂SiOR
wobei R aus der Gruppe ausgewählt ist, die aus Isopropyl, sec-Butyl, tert-Butyl, 2-Pentyl, 3-Pentyl, 3-Methyl-2-butyl, tert-Pentyl, Cyclopentyl und Cyclohexyl besteht; und Aufbringen von Energie auf die gasförmige Zusammensetzung in der Reaktionskammer, um eine Reaktion des Hydrido-Dimethyl-Alkoxysilans zu induzieren und dadurch den Organosilica-Film auf dem Substrat abzuscheiden.

2. Das Verfahren nach Anspruch 1, wobei die Zusammensetzung, die das Hydrido-Dimethyl-Alkoxysilan der Formel (1) umfasst, im Wesentlichen frei ist, d. h. weniger als 5 ppm (Gewicht), gemessen mittels Ionenchromatographie (IC), von einer oder mehreren Verunreinigungen, ausgewählt aus der Gruppe bestehend aus Halogenidverbindungen, Wasser, Metallen, sauerstoffhaltigen Verunreinigungen, stickstoffhaltigen Verunreinigungen und Kombinationen davon.

3. Das Verfahren nach Anspruch 1, wobei der Organosilicafilm eine Dielektrizitätskonstante von - 2,70 bis - 3,50, ein Elastizitätsmodul von ~ 6 bis - 36 GPa und einen XPS-Kohlenstoffgehalt von - 10 bis - 36 at. % aufweist.

4. Das Verfahren nach Anspruch 1, wobei die gasförmige Zusammensetzung, die Hydrido-Dimethyl-Alkoxysilan umfasst, frei von einem Härtungsadditiv ist.

5. Das Verfahren nach Anspruch 1, bei dem es sich um ein chemisches Gasphasenabscheidungsverfahren oder ein plasmaunterstütztes chemisches Gasphasenabscheidungsverfahren handelt.

6. Das Verfahren nach Anspruch 1, wobei die gasförmige Zusammensetzung, die Hydrido-Dimethyl-Alkoxysilan umfasst, ferner mindestens ein Oxidationsmittel umfasst, das aus der Gruppe ausgewählt ist, die aus O₂, N₂O, NO, NO₂, CO₂, CO, Wasser, H₂O₂, Ozon, Alkoholen und Kombinationen davon besteht.

7. Das Verfahren nach Anspruch 1, wobei die gasförmige Zusammensetzung, die Hydrido-Dimethyl-Alkoxysilan umfasst, kein Oxidationsmittel umfasst.

8. Das Verfahren nach Anspruch 1, wobei die Reaktionskammer während des Aufbringungsschritts mindestens ein Gas umfasst, das aus der Gruppe ausgewählt ist, die aus He, Ar, N₂, Kr, Ne und Xe besteht.

9. Das Verfahren nach Anspruch 8, wobei die Reaktionskammer während des Aufbringungsschritts ferner mindestens ein Oxidationsmittel umfasst, das aus der Gruppe ausgewählt ist, die aus O₂, N₂O, NO, NO₂, CO₂, CO, Wasser, H₂O₂, Ozon, Alkoholen und Kombinationen davon besteht.

10. Das Verfahren nach Anspruch 1, wobei der Organosilicafilm einen Brechungsindex (RI) von ~ 1,3 bis ~ 1,7 bei 632 nm aufweist.

11. Das Verfahren nach Anspruch 1, wobei der Organosilicafilm mit einer Geschwindigkeit von ~ 5 nm/min bis ~ 400 nm/min abgeschieden wird.

12. Das Verfahren nach Anspruch 1, wobei der Organosilicafilm einen Wert der relativen Methylenbrückendichte (SiCH₂Si), bestimmt durch IR-Spektroskopie, von - 10 bis ~ 30 aufweist und ferner ein Verhältnis der relativen SiCH₂Si-Dichte* zum Gesamtkohlenstoff (at. % XPS) von mehr als ~ 0,65 aufweist.

13. Das Verfahren nach Anspruch 1, wobei der Organosilicafilm einen Wert der Leckstromdichte von weniger als 1 x 10⁻⁹ A/cm² bei einer elektrischen Feldstärke von größer oder gleich 4 MV/cm aufweist.

14. Das Verfahren nach Anspruch 1, wobei R sec-Butyl ist.

15. Das Verfahren nach Anspruch 1, wobei der Organosilicafilm einen Brechungsindex (RI) von - 1,3 bis ~ 1,6 bei 632 nm und einen Stickstoffgehalt von 0,1 at. % oder weniger, gemessen durch XPS oder SIMS oder RBS, aufweist.

16. Zusammensetzung für die Aufdampfung einer dielektrischen Schicht, **dadurch gekennzeichnet, dass** sie ein Hydrido-Dimethyl-Alkoxysilan mit der in Formel (1) angegebenen Struktur umfasst:
(1) H(Me)₂SiOR,
wobei R aus der Gruppe ausgewählt ist, die aus sec-Butyl, 2-Pentyl, 3-Pentyl, 3-Methyl-2-Butyl, tert-Pentyl und Cyclohexyl besteht.

17. Die Zusammensetzung nach Anspruch 16, wobei die Zusammensetzung im Wesentlichen frei ist, d. h. weniger als 5 ppm (Gewichtsprozent), gemessen mittels Ionenchromatographie (IC), von einer oder mehreren Verunreinigungen, ausgewählt aus der Gruppe bestehend aus Halogenidverbindungen, Wasser, sauerstoffhaltigen Verunreinigungen, stickstoffhaltigen Verunreinigungen und Metallen, aufweist.

18. Die Zusammensetzung nach Anspruch 16, wobei die Zusammensetzung im Wesentlichen frei von Chloridverbindungen ist.

19. Die Zusammensetzung nach Anspruch 18, wobei die Chloridverbindungen, falls vorhanden, in einer Konzentration von 10 ppm oder weniger, gemessen mittels IC, vorhanden sind, oder
wobei die Chloridverbindungen, falls vorhanden, in einer Konzentration von 5 ppm oder weniger, gemessen mittels IC, vorhanden sind, oder
wobei die Chloridverbindungen, falls vorhanden, in einer Konzentration von 1 ppm oder weniger, gemessen mittels IC, vorhanden sind.

20. Die Zusammensetzung nach Anspruch 16, wobei die Zusammensetzung im Wesentlichen frei von stickstoffhaltigen Verunreinigungen ist.

21. Die Zusammensetzung nach Anspruch 20, wobei die stickstoffhaltigen Verunreinigungen, falls vorhanden, in einer Konzentration von ~1000 ppm oder weniger, gemessen mittels GC, vorliegen oder
wobei die stickstoffhaltigen Verunreinigungen, falls vorhanden, in einer Konzentration von ~500 ppm oder weniger, gemessen mittels GC, vorliegen.

22. Die Zusammensetzung nach Anspruch 16, die Dimethyl-tert-Pentoxysilan umfasst oder die Dimethyl-2-Pentoxysilan umfasst.

23. Eine Verbindung aus Dimethyl-sec-Butoxysilan.

## Revendications

1. Procédé de dépôt d'un film d'organosilice, le procédé comprenant :
la fourniture d'un substrat à l'intérieur d'une chambre de réaction ;
l'introduction dans la chambre de réaction d'une composition gazeuse comprenant un hydrido-diméthyl-alcoxysilane ayant la structure donnée dans la Formule (1) :
(1) H(Me)₂SiOR
dans laquelle R est choisi dans un groupe constitué de l'iso-propyle, du sec-butyle, du tert-butyle, du 2-pentyle, du 3-pentyle, du 3-méthyl-2-butyle, du tert-pentyle, du cyclopentyle et du cyclohexyle ; et
l'application d'énergie à la composition gazeuse dans la chambre de réaction pour induire une réaction de l'hydrido-diméthyl-alcoxysilane et ainsi déposer le film d'organosilice sur le substrat.

2. Procédé selon la revendication 1, dans lequel la composition comprenant l'hydrido-diméthyl-alcoxysilane de la Formule (1) est sensiblement exempte, c'est-à-dire moins de 5 ppm (en poids) mesuré par chromatographie ionique (IC), d'une ou plusieurs impuretés choisies dans un groupe constitué des composés d'halogénure, de l'eau, des métaux, des impuretés contenant de l'oxygène, des impuretés contenant de l'azote et de leurs combinaisons.

3. Procédé selon la revendication 1, dans lequel le film d'organosilice a une constante diélectrique d'environ 2,70 à environ 3,50, un module d'élasticité d'environ 6 à environ 36 GPa et une teneur en carbone XPS d'environ 10 à environ 36 % en pourcentage atomique.

4. Procédé selon la revendication 1, dans lequel la composition gazeuse comprenant un hydrido-diméthyl-alcoxysilane est exempte d'un additif durcissant.

5. Procédé selon la revendication 1, qui est un procédé de dépôt chimique en phase vapeur ou
un procédé de dépôt chimique en phase vapeur assisté par plasma.

6. Procédé selon la revendication 1, dans lequel la composition gazeuse comprenant un hydrido-diméthyl-alcoxysilane comprend en outre au moins un oxydant choisi dans un groupe constitué de O₂, N₂O, NO, NO₂, CO₂, CO, de l'eau, H₂O₂, de l'ozone, d'alcools et de leurs combinaisons.

7. Procédé selon la revendication 1, dans lequel la composition gazeuse comprenant un hydrido-diméthyl-alcoxysilane ne comprend pas un oxydant.

8. Procédé selon la revendication 1, dans lequel la chambre de réaction pendant l'étape d'application comprend au moins un gaz choisi dans un groupe constitué de He, Ar, N₂, Kr, Ne et Xe.

9. Procédé selon la revendication 8, dans lequel la chambre de réaction pendant l'étape d'application comprend en outre au moins un oxydant choisi dans un groupe constitué de O₂, N₂O, NO, NO₂, CO₂, CO, de l'eau, H₂O₂, de l'ozone, d'alcools et de leurs combinaisons.

10. Procédé selon la revendication 1, dans lequel le film d'organosilice a un indice de réfraction (RI) d'environ 1,3 à environ 1,7 à 632 nm.

11. Procédé selon la revendication 1, dans lequel le film d'organosilice est déposé à une vitesse d'environ 5 nm/min à environ 400 nm/min.

12. Procédé selon la revendication 1, dans lequel le film d'organosilice a une valeur de densité de méthylène pontant relatif (SiCH₂Si) telle que déterminée par spectrométrie IR d'environ 10 à environ 30, et a en outre un rapport de densité relative SiCH₂Si*/carbone total (en pourcentage atomique XPS) supérieur à environ 0,65.

13. Procédé selon la revendication 1, dans lequel le film d'organosilice a une valeur de densité de courant de fuite inférieure à 1 x 10⁻⁹ A/cm² à une intensité de champ électrique supérieure ou égale à 4 MV/cm.

14. Procédé selon la revendication 1, dans lequel R est le sec-butyle.

15. Procédé selon la revendication 1, dans lequel le film d'organosilice a un indice de réfraction (RI) d'environ 1,3 à environ 1,6 à 632 nm et une teneur en azote de 0,1 % en pourcentage atomique ou moins telle que mesurée par XPS ou SIMS ou RBS.

16. Composition pour le dépôt en phase vapeur d'un film diélectrique **caractérisée en ce qu'**elle comprend un hydrido-diméthyl-alcoxysilane ayant la structure donnée dans la Formule (1) :
(1) H(Me)₂SiOR
dans laquelle R est choisi dans un groupe constitué du sec-butyle, du 2-pentyle, du 3-pentyle, du 3-méthyl-2-butyle, du tert-pentyle et du cyclohexyle.

17. Composition selon la revendication 16, dans laquelle la composition est sensiblement exempte, ce qui signifie moins de 5 ppm (en poids) mesuré par chromatographie ionique (IC), d'une ou plusieurs impuretés choisies dans un groupe constitué des composés d'halogénure, de l'eau, des impuretés contenant de l'oxygène, des impuretés contenant de l'azote et des métaux.

18. Composition selon la revendication 16, dans laquelle la composition est sensiblement exempte de composés de chlorure.

19. Composition selon la revendication 18, dans laquelle les composés de chlorure, s'ils sont présents, sont présents à une concentration de 10 ppm ou moins telle que mesurée par IC ou
dans laquelle les composés de chlorure, s'ils sont présents, sont présents à une concentration de 5 ppm ou moins telle que mesurée par IC ou
dans laquelle les composés de chlorure, s'ils sont présents, sont présents à une concentration de 1 ppm ou moins telle que mesurée par IC.

20. Composition selon la revendication 16, dans laquelle la composition est sensiblement exempte d'impuretés contenant de l'azote.

21. Composition selon la revendication 20, dans laquelle les impuretés contenant de l'azote, si elles sont présentes, sont présentes à une concentration d'environ 1 000 ppm ou moins telle que mesurée par GC ou
dans laquelle les impuretés contenant de l'azote, si elles sont présentes, sont présentes à une concentration d'environ 500 ppm ou moins telle que mesurée par GC.

22. Composition selon la revendication 16, qui comprend du diméthyl-tert-pentoxysilane ou qui comprend du diméthyl-2-pentoxysilane.

23. Composé de diméthyl-sec-butoxysilane.
